(19) Europäisches Patentamt
European Patent Office
Office européen des brevets

(11) **EP 3 599 472 B1**

(12) **EUROPÄISCHE PATENTSCHRIFT**

(45) Veröffentlichungstag und Bekanntmachung des Hinweises auf die Patenterteilung:
**28.10.2020 Patentblatt 2020/44**

(51) Int Cl.:
***G01R 27/02*** *(2006.01)*     ***G01R 27/26*** *(2006.01)*
***G01R 31/50*** *(2020.01)*     ***G01R 31/58*** *(2020.01)*

(21) Anmeldenummer: **19183888.7**

(22) Anmeldetag: **02.07.2019**

(54) **VERFAHREN UND VORRICHTUNG ZUM ERFASSEN VON ISOLATIONSPARAMETERN**

METHOD AND DEVICE FOR RECORDING INSULATION PARAMETERS

PROCÉDÉ ET DISPOSITIF DE DÉTECTION DES PARAMÈTRES D'ISOLATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.07.2018 DE 102018211696**

(43) Veröffentlichungstag der Anmeldung:
**29.01.2020 Patentblatt 2020/05**

(73) Patentinhaber:
• **N-ERGIE Netz GmbH**
  **90441 Nürnberg (DE)**
• **Hochschule für angewandte Wissenschaften Coburg**
  **96450 Coburg (DE)**

(72) Erfinder:
• **Weindl, Christian**
  **90556 Seukendorf (DE)**
• **Eppelein, Friedmann**
  **91413 Neustadt/Aisch (DE)**

(74) Vertreter: **Rau, Schneck & Hübner Patentanwälte Rechtsanwälte PartGmbB Königstraße 2 90402 Nürnberg (DE)**

(56) Entgegenhaltungen:
**EP-A1- 2 256 506**     **DE-T5-112014 002 853**
**JP-A- H06 331 665**     **US-A- 4 638 242**

• **FENG YANG ET AL: "A Parameterization Approach for the Dielectric Response Model of Oil Paper Insulation Using FDS Measurements", ENERGIES, Bd. 11, Nr. 3, 10. März 2018 (2018-03-10), Seiten 1-17, XP055611720, DOI: 10.3390/en11030622**

**EP 3 599 472 B1**

**Beschreibung**

Die Erfindung betrifft ein Verfahren sowie eine Vorrichtung zum Erfassen von Isolationsparametern einer elektrischen Isolation eines Energieversorgungs-Betriebsmittels, das einen ersten und einen zweiten elektrischen Leiter hat, die mittels der elektrischen Isolation gegeneinander elektrisch isoliert sind.

Es sind unter anderem durch Vorbenutzung bereits Verfahren und Vorrichtungen bekannt, um bestimmte Eigenschaften von Isoliersystemen, wie z.B. der elektrischen Isolation eines Energieversorgungskabels als Beispiel eines Energieversorgungs-Betriebsmittels, messtechnisch zu erfassen. Diese erfassten Eigenschaften ermöglichen in gewissem Umfang und unter bestimmten Testbedingungen auch eine Zustandsbeurteilung des fraglichen Isoliersystems. An in der Feldmessung eingesetzte Verfahren und Vorrichtungen werden dabei hohe technische Anforderungen bezüglich Verfahrensweise, Gewicht und physische Ausmaße gestellt, um einerseits die notwendige Mobilität, andererseits eine effektive Messung, Untersuchung und Bewertung wirtschaftlich zu gewährleisten.

Ein solches durch Vorbenutzung bekanntes und z.B. auch in dem Fachartikel von Thomas Scharrer [et al.] "Diagnostic System for Off-Line Diagnosis of MV Cables", Proc. of the Conference on Diagnostics in Electrical Engineering CDEE 2016, 6.-8. September 2016, veröffentlicht in IEEE Xplore am 07.11.2016, Seiten 1 - 4, beschriebenes Verfahren basiert auf der Verlustfaktormessung mittels VLF (very low frequency)-Messverfahren. Hierbei wird ein Hochspannungsprüfsignal bei sehr niedriger Frequenz - typischerweise 0,1 Hz - zur Verfügung gestellt. Unbelastete Energieversorgungs-Betriebsmittel mit Isoliermedium, wie z.B. ein elektrisch isoliertes Energieversorgungskabel, verhalten sich im besten Falle rein kapazitiv. Aufgrund der reziproken Proportionalität zwischen der (hauptsächlich kapazitiven) Impedanz des Betriebsmittels und der Frequenz der angelegten Prüfspannung ergibt sich eine direkte Proportionalität zwischen bereitzustellender Leistung und Frequenz der bereitgestellten Prüfspannung. Dadurch wird der Blindleistungsbedarf gegenüber Verfahren, die mit Netzfrequenz bei 50 Hz arbeiten, um den Faktor 500 reduziert. In erster Näherung können die VLF-basierten Verfahren von der Diagnosegenauigkeit mit netzfrequenten Verfahren verglichen werden. Wie diese ermöglichen auch VLF-basierte Verfahren lediglich die Bestimmung zweier Isolationsparameter und somit die Nachbildung des Isoliermediums in Form eines einfachen Ersatzschaltbildes mit einer Parallelschaltung einer Isolationskapazität $C_{iso}$ und eines Isolationsverlustwiderstands $R_{iso}$. Das einfache Ersatzschaltbild spiegelt also eine verlustbehaftete Isolation wieder. Diagnoseungenauigkeiten können sich dadurch ergeben, dass beispielsweise durch Gleichspannungsverluste oder andere frequenzabhängige Mechanismen (z.B. Polarisationsverluste) das dielektrische Verhalten frequenzabhängig wird und somit die Messergebnisse von VLF-Messverfahren in keinen direkten Zusammenhang mit den physikalischen Gegebenheiten bei 50 Hz Netzfrequenz gebracht werden können. Als Beurteilungskriterium wird häufig der sogenannte Verlustfaktor verwendet, der aber bereits eine Reduktion des Informationsgehalts darstellt, da zu dessen Bestimmung die Wirkleistung und die Blindleistung bei der jeweiligen Frequenz der Prüfspannung ins Verhältnis gesetzt werden.

Alternativ kommen derzeit nach wie vor Verfahren zum Einsatz, bei denen betriebsfrequente Messungen des Verlustfaktors durchgeführt werden. Hierbei wird bezüglich der eingesetzten Messfrequenz der tatsächliche Betriebsfall nachgebildet und es können auch sämtliche physikalischen Effekte wie im Normalbetrieb abgebildet und untersucht werden. Die technische Ausführung der Prüfspannungsquelle, beispielsweise mittels eines oder mehrerer Transformatoren, stellt dabei infolge der bereitzustellenden Ausgangsleistung hohe Anforderungen an diese, wodurch mobile Systeme für diese Messungen groß und kostenintensiv sind.

Eine weitere durch Vorbenutzung bekannte Möglichkeit für mobil einsetzbare Verfahren basiert auf einer Resonanzprüfung, bei der die Kapazität des Energieversorgungs-Betriebsmittels, wie z.B. des Energieversorgungskabels, mit einer entsprechend einstellbaren Resonanzdrossel kompensiert wird. Der dazu benötigte Verstellmechanismus der Resonanzdrossel oder des Eisenkerns ist aber ebenfalls sehr aufwändig.

Ein weiteres durch Vorbenutzung bekanntes Verfahren beruht auf Rücckehrspannungsmessungen. Dabei wird ein Isoliermedium, wie z.B. die elektrische Isolation eines Energieversorgungskabels über längere Zeit mit einer Gleichspannung aufgeladen bzw. polarisiert. Nach einem anschließenden kurz andauernden Kurzschluss werden die sich einstellende Rücckehrspannung und deren exakter Verlauf gemessen. Durch Bestimmung verschiedener Kenngrößen des doppelt exponentiellen Verlaufs der Rücckehrspannung können qualitative Eigenschaften des Isoliermediums oder daraus berechnete Faktoren, wie z.B. der p-Faktor, abgeleitet werden. Je nach angewandter Messtechnologie und verfüg-/applizierbarer Spannungsebene sind gleichspannungsbasierte Messverfahren, wie z.B. die Rückkehrspannungsmessungen, sehr zeitintensiv (bis zu 1,5 Stunden pro Prüfling) und zudem wegen der anzuwendenden hohen Messimpedanzen sehr empfindlich gegenüber äußeren Einflüssen.

Nachteilig ist bei den bekannten Verfahren und Vorrichtungen zur Erfassung von Isolierparametern eines Isoliermediums, wie z.B. der elektrischen Isolation eines Energieversorgungskabels, dass die Beurteilung des Zustands des Isoliersystems anhand der Messung nur eines einzigen Faktors, nämlich des Verlustfaktors, welcher nicht alle physikalischen Vorgänge und Kenngrößen des Isoliermediums abbildet, und damit fehleranfällig erfolgt. Andererseits sind bei den gleichspannungsbasierten Messverfahren, wie bei den Verfahren der Rückkehrspannungsmessungen, die sehr lange Messdauer und die höchstens als Abschätzung mögliche Bestimmbarkeit der Isolationsparameter von Ersatzschaltbildern des Isoliermediums in Kauf zu nehmen. Außerdem muss bei betriebsfrequenten Messverfahren ein hoher Materialaufwand betrieben werden.

In dem Fachartikel von Feng Yang [et al.] "A Parameterization Approach for the Dielectric Response Model of Oil Paper Insulation Using FDS Measurements", Energies 2018, Volume 11, Issue 3, 622, veröffentlicht am 10.03.2018, Seiten 1 - 17, wird ein Verfahren beschrieben, bei dem im Frequenzbereich zwischen $10^{-4}$ Hz und $10^3$ Hz Messungen in Form einer Breitband-Frequenzbereichsspektroskopie an der Öl-Papier-Isolation von Hochspannungsbetriebsmitteln, insbesondere einer 126 kV-Durchführung, durchgeführt werden. Auf Basis dieser Messwerte werden die Isolationsparameter der Isolation gemäß einem Polarisations-Ersatzschaltbild in Form einer Parallelschaltung einer Isolationskapazität, eines Isolationsverlustwiderstands und mindestens einem jeweils aus einem Polarisationswiderstand und einer Polarisationskapazität gebildeten Serienschaltungszweig numerisch abgeschätzt, wobei ein Versuchs-und-Irrtums-Verfahren zum Einsatz kommt. Die Messwerterfassung sowie die nachfolgende numerische Auswertung sind aufwändig. Außerdem handelt es sich bei den so ermittelten Isolationsparametern um Schätzwerte, welche zwangsläufig immer mit einer mehr oder weniger ausgeprägten Ungenauigkeit behaftet sind.

Die Aufgabe der Erfindung besteht nun darin, ein Verfahren der eingangs bezeichneten Art anzugeben, das gegenüber den bekannten Verfahren zur Erfassung von Isolierparametern eines Isoliermediums Verbesserungen aufweist.

Zur Lösung dieser Aufgabe wird ein Verfahren entsprechend den Merkmalen des Patentanspruchs 1 angegeben. Bei dem erfindungsgemäßen Verfahren handelt es sich um ein solches, bei dem anhand einer bei einer ersten Frequenz durchgeführten ersten Messung am Energieversorgungs-Betriebsmittel zwei erste reelle Immitanz-Anteile einer zwischen dem ersten und dem zweiten Leiter liegenden ersten komplexen Immitanz ermittelt werden, und mindestens anhand einer bei einer von der ersten Frequenz verschiedenen zweiten Frequenz durchgeführten zweiten Messung am Energieversorgungs-Betriebsmittel zwei zweite reelle Immitanz-Anteile einer zweiten komplexen Immitanz ermittelt werden. Weiterhin werden anhand der zwei ersten reellen Immitanz-Anteile und der zwei zweiten reellen Immitanz-Anteile vier erste Isolationsparameter der elektrischen Isolation gemäß einem Polarisations-Ersatzschaltbild in Form einer parallelen Isolationskapazität $C_{iso}$, eines parallelen Isolationsverlustwiderstands $R_{iso}$, eines ersten Polarisationswiderstands $R_{Pol1}$ und einer ersten Polarisationskapazität $C_{Pol1}$ bestimmt, wobei gemäß dem Polarisations-Ersatzschaltbild die Isolationskapazität $C_{iso}$, der Isolationsverlustwiderstand $R_{iso}$ sowie die Serienschaltung des ersten Polarisationswiderstands $R_{Pol1}$ und der ersten Polarisationskapazität $C_{Pol1}$ parallel zueinander geschaltet sind.

Der Begriff (komplexe) Immitanz steht hier insbesondere als Sammelbezeichnung oder Oberbegriff für eine (komplexe) Impedanz und eine (komplexe) Admittanz. Die komplexe Immitanz kann also insbesondere entweder einen komplexen Widerstand oder einen komplexen Leitwert bezeichnen. Außerdem kann es sich bei den zwei (ersten oder zweiten) reellen Immitanz-Anteilen insbesondere jeweils entweder um einen (ersten oder zweiten) Immitanz-Realteil und einen (ersten oder zweiten) Immitanz-Imaginärteil oder um einen (ersten oder zweiten) Immitanz-Betrag und eine (erste oder zweite) Immitanz-Phase handeln.

Das erfindungsgemäße Verfahren ermöglicht eine erweiterte Zustandsdiagnose anhand der komplexen Messungen der Impedanz oder Admittanz der elektrischen Isolation (= Isoliermedium) des Energieversorgungs-Betriebsmittels bei mindestens zwei Frequenzen. Erfasst werden pro Frequenz jeweils Wirk- und Blindanteil der Impedanz oder Admittanz des Isoliermediums, insgesamt also mindestens vier voneinander unabhängige Messwerte. Dabei haben diese Messungen einen vergleichbar geringen Zeitbedarf und außerdem eine ähnliche erzielbare Genauigkeit und Auflösung wie die bekannten Verlustfaktor-Messverfahren. Darüber hinaus bieten sie mindestens auch die erweiterten Diagnosemöglichkeiten der bekannten gleichspannungsbasierten Messverfahren. So können anhand des erstmals insbesondere analytisch quantitativ bestimmten Polarisations-Ersatzschaltbilds beispielsweise Aussagen zu Polarisationsprozessen, z.B. zur Grenzschichtpolarisation, in der Isolation getroffen werden. Das erfindungsgemäße Verfahren vereint also die jeweiligen Vorteile der bekannten Verfahren und bietet darüber hinaus weitere Vorzüge.

Bei der komplexen Messung der Impedanz oder Admittanz werden im Grunde immer zwei unterschiedliche Größen ermittelt. Je nach Darstellungsart - algebraische Form oder Polarform - stehen somit immer zwei Größen für die weitere Verarbeitung zur Verfügung. Real- und Imaginärteil bzw. Betrag und Phase der komplexen Impedanz oder Admittanz. Die Messung der komplexen Impedanz oder Admittanz bei zwei unterschiedlichen Frequenzen resultiert in vier unterschiedlichen Messgrößen, die zur weiteren Analyse und Beurteilung zur Verfügung stehen. Bekannte Messverfahren liefern demgegenüber entweder nur weniger unabhängige Messgrößen oder nur Messgrößen mit einem geringeren Informationsgehalt, und/oder sie sind mit einem erheblich höheren Erfassungsaufwand oder einer erheblich längeren Erfassungsdauer verbunden.

Außerdem kann die Ermittlung der zwei ersten und zweiten Immitanz-Anteile bei der ersten bzw. zweiten Frequenz beispielsweise auch anhand eines (komplexen) Frequenzscans erfolgen, zu dessen Ermittlung die elektrische Isolation sukzessive mit mehreren Prüfsignalen mit jeweils voneinander verschiedener Frequenz beaufschlagt wird. Aus dem sich so - ggf. nach einer datentechnischen Aufbereitung - ergebenden Frequenzscan (z.B. mit Betrag und Phase der Immitanz) können dann die zwei ersten und zweiten Immitanz-Anteile für zwei sich voneinander unterscheidende Frequenzen (entsprechend der ersten und zweiten Frequenz) entnommen werden. Auch diese Vorgehensweise ist hier unter "einer bei einer ersten Frequenz durchgeführten ersten Messung" und "einer bei einer von der ersten Frequenz verschiedenen zweiten Messung" zu verstehen.

Unter einem Energieversorgungs-Betriebsmittel ist hier beispielsweise ein Energieversorgungskabel, ein elektrischer Transformator oder eine andere im Energieversorgungsbereich eingesetzte elektrische Komponente mit einer elektrischen Isolation zwischen zwei elektrischen Leitern zu verstehen.

Bei einer Ausgestaltung des Energieversorgungs-Betriebsmittels als Energieversorgungskabel können insbesondere die erste Messung und die zweite Messung an der gleichen Stelle am Energieversorgungskabel durchgeführt werden, beispielsweise an einem der beiden Kabelenden des Energieversorgungskabels. Letztere befinden sich im verlegten Zustand des Energieversorgungskabels bevorzugt jeweils innerhalb einer Unterstation des zugehörigen Energieversorgungssystems und sind dort vorteilhafterweise auch für einen elektrischen Anschluss der Prüfausrüstung zugänglich. Dies ist aber nicht zwingend. So könnten die beiden Messungen mit unterschiedlichen Frequenzen prinzipiell auch an verschiedenen Stellen des Energieversorgungskabels, wie z.B. an jeweils einem anderem der beiden Kabelenden, stattfinden. Die beiden Messungen können außerdem auch an einem unverlegten Energieversorgungskabel durchgeführt werden, beispielsweise im Labor. Dort sind die beiden Kabelenden ohne weiteres zugänglich.

Vorteilhafte Ausgestaltungen des erfindungsgemäßen Verfahrens ergeben sich aus den Merkmalen der von Anspruch 1 abhängigen Ansprüche.

Günstig ist eine Ausgestaltung, bei der sich die erste Frequenz und die zweite Frequenz um einen Faktor von mindestens 2 vorzugsweise um einen Faktor von mindestens 10 und höchst vorzugsweise um einen Faktor von mindestens 500 voneinander unterscheiden. Insbesondere liegen die erste Frequenz und die zweite Frequenz um einen Faktor von höchstens $10^{11}$ und vorzugsweise von höchstens $10^{10}$ auseinander. Dann fallen die jeweiligen Informationsgehalte der mindestens vier Messgrößen vorteilhafterweise deutlich auseinander und sind insbesondere auch voneinander unterscheidbar. Der in weiten Grenzen wählbare Unterschied zwischen der ersten Frequenz und der zweiten Frequenz ist insbesondere auch durch messtechnisehe und -praktische Gegebenheiten festgelegt. Derzeit liegt der mit vertretbarem Aufwand ausschöpfbare Wertebereich für die erste Frequenz und die zweite Frequenz insbesondere zwischen etwa 1 μHz und 10 kHz.

Gemäß einer weiteren günstigen Ausgestaltung liegt die erste Frequenz im Bereich zwischen etwa 0,01 Hz und 1 Hz, und beträgt insbesondere etwa 0,1 Hz. Letzteres ist die Frequenz einer im Feld etablierten Diagnosemessung. Somit stehen hierfür entsprechende Hochspannungsgeneratoren zur Verfügung.

Gemäß einer weiteren günstigen Ausgestaltung ist die zweite Frequenz eine Netzfrequenz, insbesondere 50 Hz oder 60 Hz. Dann kann man vorteilhafterweise einen am Netz angeschlossenen Transformator zur Erzeugung des Prüfsignals verwenden.

Gemäß einer weiteren günstigen Ausgestaltung werden die beiden Messungen mit unterschiedlicher Prüfspannung eines angelegten Prüfsignals durchgeführt. Dadurch können Abhängigkeiten der ermittelten Messgrößen und der daraus bestimmten Isolationsparameter, insbesondere der Parameter des Ersatzschaltbilds, von der Prüfspannung als weitere Diagnosekenngrößen verwendet werden.

Gemäß einer weiteren günstigen Ausgestaltung sind die zwei ersten reellen Immitanz-Anteile ein erster Admittanz-Realteil $G_{\omega 1}$ und ein erster Admittanz-Imaginärteil $B_{\omega 1}$ und die zwei zweiten reellen Immitanz-Anteile ein zweiter Admittanz-Realteil $G_{\omega 2}$ und ein zweiter Admittanz-Imaginärteil $B_{\omega 2}$, wobei die Isolationskapazität $C_{iso}$ gemäß:

$$C_{iso} = \frac{-(B_{w_1} B_{w_2} w_1^2 + (-B_{w_1}{}^2 - B_{w_2}{}^2 - G_{w_1}{}^2 + 2G_{w_1} G_{w_2} - G_{w_2}{}^2) w_1 w_2 + B_{w1} B_{w2} w_2^2)}{((w_1^2 - w_2^2)(B_{w_1} w_2 - B_{w_2} w_1))}$$

der Isolationsverlustwiderstand $R_{iso}$ gemäß:

$$R_{iso} = \frac{-((G_{w_1} - G_{w_2})(w_1^2 - w_2^2))}{(B_{w_1}^2 w_2^2 - 2B_{w_1} B_{w_2} w_1 w_2 + B_{w_2}^2 w_1^2 + G_{w_1}^2 w_2^2 - G_{w_1} G_{w_2} w_1^2 - G_{w_1} G_{w_2} w_2^2 + G_{w_2}{}^2 w_1^2)}$$

der erste Polarisationswiderstand $R_{Pol1}$ gemäß:

$$R_{pol1} = ((G_{w_1} - G_{w_2})(w_1^2 - w_2^2)(B_{w_1}w_2 - B_{w_2}w_1)^2) /$$

$$((B_{w_1}w_2 - B_{w_2}w_1)^4 + B_{w_1}^2 w_2^2 (w_1^2 + w_2^2)(G_{w_1} - G_{w_2})^2 - 2B_{w_1}B_{w_2}w_1^3 w_2 (G_{w_1} - G_{w_2})^2 -$$

$$2B_{w_1}B_{w_2}w_1 w_2^3 (G_{w_1} - G_{w_2})^2 + B_{w_2}^2 w_1^4 (G_{w_1} - G_{w_2})^2 + B_{w_2}^2 w_1^2 w_2^2 (G_{w_1} - G_{w_2})^2 + w_1^2 w_2^2 (G_{w_1} - G_{w_2})^4)$$

und die erste Polarisationskapazität $C_{Pol1}$ gemäß:

$$C_{pol1} = \frac{-(((B_{w_1}w_2 - B_{w_2}w_1)^2 + w_1^2 (G_{w_1} - G_{w_2})^2)((B_{w_1}w_2 - B_{w_2}w_1)^2 + w_2^2 (G_{w_1} - G_{w_2})^2))}{(w_1 w_2 (w_1 + w_2)(G_{w_1} - G_{w_2})^2 (B_{w_1}w_2 - B_{w_2}w_1)(w_1 - w_2))}$$

bestimmt wird, und wobei $\omega_1$ die zur ersten Frequenz gehörige Kreisfrequenz und $\omega_2$ die zur zweiten Frequenz gehörige Kreisfrequenz ist. Die vier ersten Isolationsparameter $C_{iso}$, $R_{iso}$, $R_{Pol1}$, $C_{Pol1}$ gemäß dem Polarisations-Ersatzschaltbild lassen sich anhand der vorstehend genannten vier Gleichungen exakt und außerdem mit vergleichsweise geringem Aufwand aus den vier ermittelten Messgrößen, hier dem bei der ersten Frequenz ermittelten ersten Admittanz-Realteil $G_{\omega_1}$, dem ebenfalls bei der ersten Frequenz ermittelten ersten Admittanz-Imaginärteil $B_{\omega_1}$, dem bei der zweiten Frequenz ermittelten zweiten Admittanz-Realteil $G_{\omega_2}$ und dem ebenfalls bei der zweiten Frequenz ermittelten zweiten Admittanz-Imaginärteil $B_{\omega_2}$, bestimmen.

Günstig ist eine weitere Ausgestaltung, bei der anhand mindestens einer bei einer von der ersten und der zweiten Frequenz verschiedenen weiteren Frequenz durchgeführten weiteren Messung am Energieversorgungs-Betriebsmittel pro weiterer Messung zwei weitere reelle Immitanz-Anteile einer weiteren komplexen Immitanz ermittelt werden, und pro weiterer Messung anhand der ersten und zweiten reellen Immitanz-Anteile gemäß einem weiteren Polarisations-Ersatzschaltbild jeweils zwei weitere erste Isolationsparameter der elektrischen Isolation in Form eines weiteren Polarisationswiderstands $R_{Pol2}$ und einer weiteren Polarisationskapazität $C_{Pol2}$ bestimmt werden, wobei die Serienschaltung des weiteren Polarisationswiderstands $R_{Pol2}$ und der weiteren Polarisationskapazität $C_{Pol2}$ gemäß dem weiteren Polarisations-Ersatzschaltbild parallel zu der Isolationskapazität $C_{iso}$, zu dem Isolationsverlustwiderstand $R_{iso}$ sowie zu der Serienschaltung des ersten Polarisationswiderstands $R_{Pol1}$ und der ersten Polarisationskapazität $C_{Pol1}$ geschaltet ist. Alle weiteren Frequenzen weiterer Messungen werden dabei insbesondere jeweils so gewählt, dass sich alle Frequenzen voneinander unterscheiden. Alle weiteren Polarisationswiderstände $R_{Pol2}$ bzw. $R_{Poli}$ und alle weiteren Polarisationskapazitäten $C_{Pol2}$ bzw. $C_{Poli}$ lassen sich anhand aller bei den Messungen mit verschiedenen Frequenzen ermittelten ersten und zweiten reellen Immitanz-Anteile ohne weiteres bestimmen. Der Rechenweg ist dabei analog zu dem zur Bestimmung der ersten vier ersten Isolationsparamater $C_{iso}$, $R_{iso}$, $R_{Pol1}$, $C_{Pol1}$ anhand von zwei Messungen bei zwei unterschiedlichen Frequenzen. Durch die Bestimmung und Berücksichtigung weiterer Polarisationswiderstände $R_{Pol2}$ bzw. $R_{Poli}$ und weiterer Polarisationskapazitäten $C_{Pol2}$ bzw. $C_{Poli}$ kann das Polarisations-Ersatzschaltbild weiter verfeinert werden, so dass es das Isolationsverhalten des Isoliermediums noch genauer beschreibt. Damit lassen sich dann auch die Folgeauswertungen beispielsweise zum Isolationszustand des Energieversorgungs-Betriebsmittels mit einer noch höheren Qualität vornehmen.

Gemäß einer weiteren günstigen Ausgestaltung werden anhand der Isolationskapazität $C_{iso}$, des Isolations-verlustwiderstands $R_{iso}$, des ersten Polarisationswiderstands $R_{Pol1}$ und der ersten Polarisationskapazität $C_{Pol1}$ gemäß dem Polarisations-Ersatzschaltbild vier zweite Isolationsparameter der elektrischen Isolation gemäß einem Maxwell-Ersatzschaltbild in Form eines ersten Maxwell-Widerstands $R_{MW1}$, einer ersten Maxwell-Kapazität $C_{MW1}$, eines zweiten Maxwell-Widerstands $R_{MW2}$ und einer zweiten Maxwell-Kapazität $C_{MW2}$ bestimmt, wobei gemäß dem Maxwell-Ersatzschaltbild die Parallelschaltung des ersten Maxwell-Widerstands $R_{MW1}$ und der ersten Maxwell-Kapazität $C_{MW1}$ und die Parallelschaltung des zweiten Maxwell-Widerstands $R_{MW2}$ und der zweiten Maxwell-Kapazität $C_{MW2}$ in Reihe geschaltet sind. Anhand des Maxwell-Ersatzschaltbilds und insbesondere durch die vollständige Ermittlung der vier zweiten Isolationsparameter $R_{MW1}$, $C_{MW1}$, $R_{MW2}$, $C_{MW2}$ des Maxwell-Ersatzschaltbilds lassen sich vorzugsweise Aussagen zum Isolationsverhalten von geschichteten Dielektrika bzw. Mehrschicht-Dielektrika, wie z.B. von den häufig im Bereich der Transformatoren- und Kabeltechnologien verwendeten Papier-Öl-Dielektrika bzw. Papier-Masse-Dielektrika oder auch mit Leitschichten versehenen Kunststoffisolierungen, treffen. In diesem Fall würden beispielsweise zum einen der erste Maxwell-Widerstand $R_{MW1}$ und die erste Maxwell-Kapazität $C_{MW1}$ zusammenfassend für alle öl- oder massegetränkten Papierschichten, und zum anderen der zweite Maxwell-Widerstand $R_{MW2}$ und die zweite Maxwell-Kapazität $C_{MW2}$ für die dazwischenliegenden Öl- bzw. Masse-Schichten stehen.

Gemäß einer weiteren günstigen Ausgestaltung werden der erste Maxwell-Widerstand $R_{MW1}$, die erste Maxwell-Kapazität $C_{MW1}$, der zweite Maxwell-Widerstand $R_{MW2}$ und die zweite Maxwell-Kapazität $C_{MW2}$ aus den vier ersten Isolationsparametern $C_{iso}$, $R_{iso}$, $R_{Pol1}$, $C_{Pol1}$ gemäß den Gleichungen (10) bis (13) (siehe nachfolgend in der Figurenbeschreibung) bestimmt.

Günstig ist eine weitere Ausgestaltung, bei der anhand mindestens einer bei einer von der ersten und der zweiten Frequenz verschiedenen weiteren Frequenz durchgeführten weiteren Messung am Energieversorgungs-Betriebsmittel pro weiterer Messung zwei weitere reelle Immitanz-Anteile einer weiteren komplexen Immitanz ermittelt werden, und pro weiterer Messung anhand der ersten und zweiten reellen Immitanz-Anteile gemäß einem weiteren Polarisations-Ersatzschaltbild jeweils zwei weitere erste Isolationsparameter der elektrischen Isolation in Form eines weiteren Polarisationswiderstands $R_{Pol2}$ und einer weiteren Polarisationskapazität $C_{Pol2}$ bestimmt werden, und anhand der Isolationskapazität $C_{iso}$, des Isolationsverlustwiderstands $R_{iso}$, des ersten Polarisationswiderstands $R_{Pol1}$, der ersten Polarisationskapazität $C_{Pol1}$, des weiteren Polarisationswiderstands $R_{Pol2}$ und der weiteren Polarisationskapazität $C_{Pol2}$ gemäß dem weiteren Polarisations-Ersatzschaltbild zwei weitere zweite Isolationsparameter der elektrischen Isolation gemäß einem weiteren Maxwell-Ersatzschaltbild in Form eines weiteren Maxwell-Widerstands $R_{MW3}$ und einer weiteren Maxwell-Kapazität $C_{MW3}$ bestimmt werden, wobei gemäß dem weiteren Maxwell-Ersatzschaltbild die Parallelschaltung des weiteren Maxwell-Widerstands $R_{MW3}$ und der weiteren Maxwell-Kapazität $C_{MW3}$ in Reihe zur Reihenschaltung der beiden Parallelschaltungen des ersten Maxwell-Widerstands $R_{MW1}$ und der ersten Maxwell-Kapazität $C_{MW1}$ einerseits und des zweiten Maxwell-Widerstands $R_{MW2}$ und der zweiten Maxwell-Kapazität $C_{MW2}$ andererseits geschaltet ist. Der Rechenweg ist dabei analog zu dem zur Bestimmung der ersten vier zweiten Isolationsparamater $R_{MW1}$, $C_{MW1}$, $R_{MW2}$, $C_{MW2}$ anhand von zwei Messungen bei zwei unterschiedlichen Frequenzen. Durch die Bestimmung und Berücksichtigung weiterer Maxwell-Widerstände $R_{MW3}$ bzw. $R_{MWi}$ und weiterer Maxwell-Kapazitäten $C_{MW3}$ bzw. $C_{MWi}$ kann auch das Maxwell-Ersatzschaltbild weiter verfeinert werden, so dass es das Isolationsverhalten des Isoliermediums noch genauer beschreibt. Damit lassen sich dann auch die Folgeauswertungen beispielsweise zum Isolationszustand des Energieversorgungs-Betriebsmittels mit einer noch höheren Qualität vornehmen.

Gemäß einer weiteren günstigen Ausgestaltung wird anhand der bestimmten Isolationsparameter entweder unmittelbar oder mittelbar nach Durchführung von Folgeberechnungen unter Verwendung der Isolationsparameter das Isolationsverhalten des Energieversorgungs-Betriebsmittels, insbesondere eines bevorzugt verlegten Energieversorgungskabels, insbesondere mindestens eine der Größen aus volumen- oder massebezogener Wasseranteil der elektrischen Isolation, Trockenmasseanteil der elektrischen Isolation, Alterungszustand der elektrischen Isolation und Restlebensdauer der elektrischen Isolation, ermittelt. Der volumen- oder massebezogener Wasseranteil und der Trockenmasseanteil der elektrischen Isolation sind dabei insbesondere Kennzeichen für den qualitativen Zustand bzw. Alterungszustand eines Isoliersystems. Vorzugsweise können der Wasseranteil und/oder der Trockenmasseanteil jeweils in den unterschiedlichen Schichten der elektrischen Isolation ermittelt (und ausgewertet) werden. Unter Verwendung der Isolationsparameter der jeweiligen Ersatzschaltbilder lassen sich vorteilhafterweise auch Aussagen über den (Isolations-)Zustand des Energieversorgungs-Betriebsmittels treffen, die bislang gar nicht oder nur unter erheblich größerem Aufwand möglich waren.

Eine weitere Aufgabe der Erfindung besteht darin, eine Vorrichtung der eingangs bezeichneten Art anzugeben, die gegenüber den bekannten Vorrichtungen zur Erfassung von Isolierparametern eines Isoliermediums Verbesserungen aufweist.

Zur Lösung der die Vorrichtung betreffenden Aufgabe wird eine Vorrichtung entsprechend den Merkmalen des Anspruchs 10 angegeben. Die erfindungsgemäße Vorrichtung hat eine Quelleinheit zur Erzeugung eines ersten Prüfsignals mit einer ersten Frequenz und mindestens eines zweiten Prüfsignals mit einer von der ersten Frequenz verschiedenen zweiten Frequenz, eine Messeinheit die dazu ausgelegt ist, das erste Prüfsignal im Rahmen einer ersten Messung und das zweite Prüfsignal im Rahmen einer zweiten Messung an das Energieversorgungs-Betriebsmittel anzulegen und eine mit der Quelleinheit und der Messeinheit datentechnisch in Verbindung stehende Steuer-/Auswerteeinheit. Dabei ist die Messeinheit oder die Steuer-/Auswerteeinheit dazu ausgelegt, anhand der ersten Messung zwei erste reelle Immitanz-Anteile einer zwischen dem ersten und dem zweiten Leiter des Energieversorgungs-Betriebsmittels liegenden ersten komplexen Immitanz zu ermitteln, und anhand der zweiten Messung zwei zweite reelle Immitanz-Anteile einer zwischen dem ersten und dem zweiten Leiter des Energieversorgungs-Betriebsmittels liegenden zweiten komplexen Immitanz zu ermitteln. Dabei ist die Steuer-/Auswerteeinheit weiterhin dazu ausgelegt, anhand der zwei ersten reellen Immitanz-Anteile und der zwei zweiten reellen Immitanz-Anteile vier erste Isolationsparameter der elektrischen Isolation gemäß einem Polarisations-Ersatzschaltbild in Form einer parallelen Isolationskapazität $C_{iso}$, eines parallelen Isolationsverlustwiderstands $R_{iso}$, eines ersten Polarisationswiderstands $R_{Pol1}$ und einer ersten Polarisationskapazität $C_{Pol1}$ zu bestimmen, wobei gemäß dem Polarisations-Ersatzschaltbild die Isolationskapazität $C_{iso}$, der Isolationsverlustwiderstand $R_{iso}$ sowie die Serienschaltung des ersten Polarisationswiderstands $R_{Pol1}$ und der ersten Polarisationskapazität $C_{Pol1}$ parallel zueinander geschaltet sind.

Die Quelleinheit kann insbesondere auch zwei oder mehr Teilquellen enthalten, wobei beispielsweise jede der Teilquellen jeweils eines der Prüfsignale unterschiedlicher Frequenz erzeugt.

Die Messeinheit ist insbesondere auch dazu ausgelegt, ein aufgrund des an das Energieversorgungs-Betriebsmittel angelegten ersten Prüfsignals resultierendes erstes Antwortsignal sowie ein aufgrund des an das Energieversorgungs-Betriebsmittel angelegten zweiten Prüfsignals resultierendes zweites Antwortsignal zu erfassen.

Die Vorrichtung kann zumindest teilweise Bestandteil eines mobilen Messwagens zur Prüfung von Energieversorgungs-Betriebsmitteln, insbesondere von Energieversorgungskabeln, vorzugsweise von verlegten Energieversorgungskabeln, sein. Weiterhin kann die Steuer-/Auswerteinheit mehrere Teilkomponenten aufweisen. Insbesondere kann sie als eine der Teilkomponenten eine zentrale Recheneinheit haben. Letztere kann dann insbesondere auch außerhalb des mobilen Messwagens an einem festen Standort platziert sein. Auf dieser zentralen Recheneinheit können vorzugsweise rechenintensive Operationen durchgeführt werden.

Vorteilhafte Ausgestaltungen der erfindungsgemäßen Vorrichtung ergeben sich aus den Merkmalen der von Anspruch 10 abhängigen Ansprüche. Die erfindungsgemäße Vorrichtung und ihre Ausgestaltungen bieten im Wesentlichen die gleichen Vorteile, die bereits im Zusammenhang mit dem erfindungsgemäßen Verfahren und dessen Ausgestaltungen beschrieben worden sind.

Weitere Merkmale, Vorteile und Einzelheiten der Erfindung ergeben sich aus der nachfolgenden Beschreibung von Ausführungsbeispielen anhand der Zeichnung. Es zeigt:

Fig. 1 ein Ausführungsbeispiel einer Vorrichtung zum Erfassen von Isolationsparametern eines Energieversorgungskabels,

Fig. 2 ein Polarisations-Ersatzschaltbild für die elektrische Isolation des Energieversorgungskabels gemäß Fig. 1,

Fig. 3 ein erweitertes Polarisations-Ersatzschaltbild für die elektrische Isolation des Energieversorgungskabels gemäß Fig. 1,

Fig. 4 ein Maxwell-Ersatzschaltbild für die elektrische Isolation des Energieversorgungskabels gemäß Fig. 1 und

Fig. 5 ein erweitertes Maxwell-Ersatzschaltbild für die elektrische Isolation des Energieversorgungskabels gemäß Fig. 1.

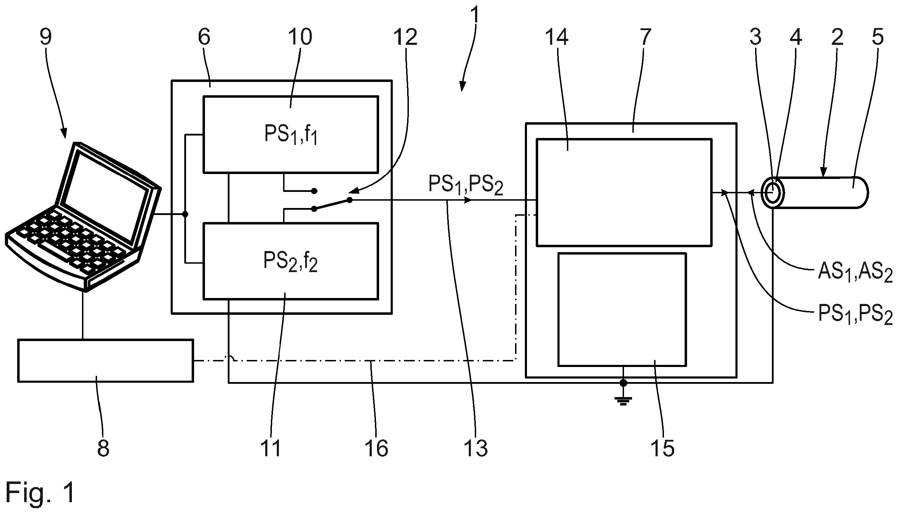

Einander entsprechende Teile sind in den Fig. 1 bis 5 mit denselben Bezugszeichen versehen. Auch Einzelheiten der im Folgenden näher erläuterten Ausführungsbeispiele können für sich genommen eine Erfindung darstellen oder Teil eines eigenen Erfindungsgegenstands sein.

In Fig. 1 ist ein Ausführungsbeispiel einer Erfassungsvorrichtung 1 zum Erfassen von Isolationsparametern eines Energieversorgungskabels 2 gezeigt. Das Energieversorgungskabel 2 ist ein Beispiel für ein Energieversorgungs-Betriebsmittel. Das Energieversorgungskabel 2 ist im gezeigten Ausführungsbeispiel ein Mittelspannungsversorgungskabel für eine Netzspannung von insbesondere 20 kV. Es hat einen konzentrischen Aufbau mit einem Innenleiter 3, der von einer elektrischen Isolation 4 und einem Außenleiter 5 umgeben ist. Die elektrische Isolation 4 befindet sich zwischen dem Innenleiter 3 und dem Außenleiter 5 und isoliert die beiden Leiter 3 und 5 elektrisch voneinander. Sie stellt insofern ein Isoliermedium dar.

Die Erfassungsvorrichtung 1 hat eine Quelleinheit 6 zur Erzeugung von Prüfsignalen $PS_1$, $PS_2$ unterschiedlicher Frequenz, eine Messeinheit 7 zur Einspeisung der Prüfsignale $PS_1$, $PS_2$ in das Energieversorgungskabel 2 und zur Erfassung entsprechender Antwortsignale $AS_1$, $AS_2$ von dem Energieversorgungskabel 2, eine Übertragungseinheit 8 und eine Steuer-/ Auswerteeinheit 9. Letztere ist datentechnisch an die Quelleinheit 6 und über die Übertragungseinheit 8 an die Messeinheit 7 angeschlossen. Die Quelleinheit 6 kann mehrere Signalquellen enthalten. Im gezeigten Ausführungsbeispiel sind dies eine erste Signalquelle 10 und eine zweite Signalquelle 11. Die erste Signalquelle 10 erzeugt das erste Prüfsignal $PS_1$ mit der ersten Frequenz $f_1$ von beispielsweise 0,1 Hz, die zweite Signalquelle 11 das zweite Prüfsignal $PS_2$ mit der zweiten Frequenz $f_2$ von beispielsweise 50 Hz. Die erste Frequenz $f_1$ und die zweite Frequenz $f_2$ unterscheiden sich somit insbesondere um den Faktor 500 voneinander. Weitere Signalquellen können vorhanden sein. Die von den Signalquellen 10, 11 erzeugten Prüfsignale $PS_1$, $PS_2$ werden über einen Schalter 12 und eine Hochspannungsmessleitung 13 sequentiell der Messeinheit 7 zugeführt. Letztere hat ein hochgenaues Widerstandsmesssystem 14 sowie einen Spannungsteiler 15 und ist mittels einer Datenleitung 16 über die Aufbereitungseinheit 8, die zur messtechnischen Steuerung, zur Übertragung der Messdaten und/oder zur Potentialtrennung dient und bei Bedarf eine Datenaufbereitung und/oder Datenkonversion der von der Messeinheit 7 gelieferten Messdaten vornimmt, mit der Steuer-/Auswerteeinheit 9 verbunden.

Zumindest ein Teil der Erfassungsvorrichtung 1 kann in einem in Fig. 1 nicht näher gezeigten mobilen Messwagen für (Isolations-)Prüfungen an verlegten Energieversorgungskabeln untergebracht sein. So können sich insbesondere die Quelleinheit 6, die Aufbereitungseinheit 8 und die Steuer-/Auswerteeinheit 9, letztere komplett oder auch nur in Teilen, in dem Messwagen befinden. Die Messeinheit 7 befindet sich zumindest für die Dauer der Messungen z.B. in einer Unterstation, in der ein Kabelende des zu prüfenden verlegten Energieversorgungskabels 2 für einen Anschluss der Messgerätschaften zugänglich ist. Alternativ kann die Messeinheit 7 aber auch während der Messungen im Messwagen platziert sein. Dann werden die in die Messungen mit eingehenden Beiträge der Verbindungsleitungen zu der Unterstation von den Messergebnissen insbesondere wieder abgezogen.

Prinzipiell kann die Erfassungsvorrichtung 1 aber auch in anderer Form und insbesondere auch nicht-mobil, beispielsweise im Labor, zum Einsatz kommen.

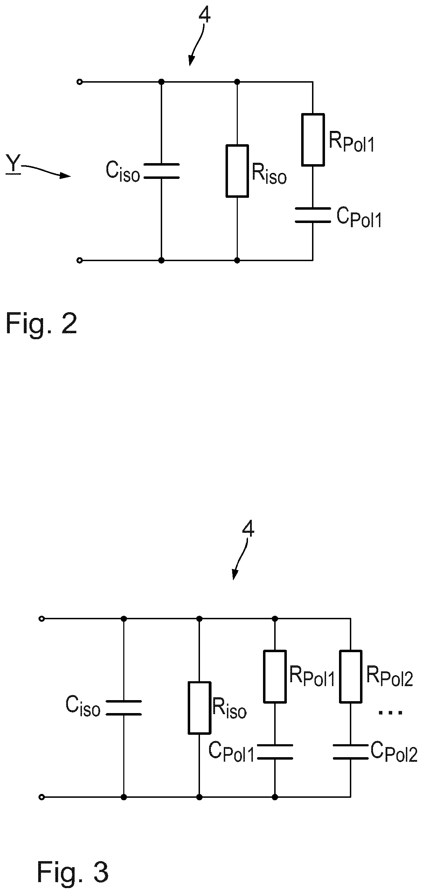

Im Folgenden wird auch unter Bezugnahme auf die in Fig. 2 bis 5 gezeigten Ersatzschaltbilder der elektrischen Isolation 4 des Energieversorgungskabels 2 die Funktionsweise der Erfassungsvorrichtung 1 näher erläutert. Die Erfassungsvorrichtung 1 funktioniert bei anderen Energieversorgungs-Betriebsmitteln, wie z.B. einem elektrischen Transformator, analog.

In der Erfassungsvorrichtung 1 wird eine komplexe Messung der Impedanz oder Admittanz der elektrischen Isolation 4 des Energieversorgungskabels 2 bei mindestens der ersten und der zweiten Frequenz $f_1$, $f_2$ durchgeführt. Auf Basis der nacheinander an das Energieversorgungskabel 2 angelegten Prüfsignale $PS_1$, $PS_2$ und der jeweils resultierenden Antwortsignale $AS_1$, $AS_2$ werden in der Messeinheit 7 pro Frequenz $f_1$, $f_2$ jeweils Wirk- und Blindanteil der Impedanz oder Admittanz der elektrischen Isolation 4 des Energieversorgungskabels 2. Bei einem alternativen Ausführungsbeispiel kann diese Ermittlung in der Steuer-/Auswerteeinheit 9 erfolgen. Insgesamt liegen dann in der Messeinheit 7 oder in der Steuer-/Auswerteeinheit 9 also mindestens vier voneinander unabhängige hochgenaue Messwerte vor, nämlich z.B. ein bei der ersten Frequenz $f_1$ ermittelter erster Admittanz-Realteil $G_{\omega_1}$, ein ebenfalls bei der ersten Frequenz $f_1$ ermittelter erster Admittanz-Imaginärteil $B_{\omega_1}$, ein bei der zweiten Frequenz $f_2$ ermittelter zweiter Admittanz-Realteil $G_{\omega_2}$ und ein ebenfalls bei der zweiten Frequenz $f_2$ ermittelter zweiter Admittanz-Imaginärteil $B_{\omega_2}$. Diese vier unterschiedlichen Messgrößen stehen zur weiteren Analyse und Beurteilung zur Verfügung.

Zunächst wird das für die elektrische Isolation 4 aufgestellte Polarisations-Ersatzschaltbild gemäß Fig. 2 herangezogen. Dessen Isolationsparameter, nämlich die Isolationskapazität $C_{iso}$, der Isolationsverlustwiderstand $R_{iso}$, der erste Polarisationswiderstand $R_{Pol1}$ und die erste Polarisationskapazität $C_{Pol1}$, werden dabei anhand der angesprochenen vier Messwerte $G_{\omega_1}$, $B_{\omega_1}$, $G_{\omega_2}$, $B_{\omega_2}$ bestimmt. Mit den bekannten Methoden der Netzwerkanalyse errechnet sich die komplexe Eingangsadmittanz $\underline{Y}(\omega)$ der Schaltung gemäß Fig. 2 zu:

$$\underline{Y}(\omega) = \frac{1}{R_{iso}} + \frac{(\omega C_{Pol1})^2 R_{Pol1}}{1 + (\omega R_{Pol1} C_{Pol1})^2} + j\omega C_{iso} + j\frac{\omega C_{Pol1}}{1 + (\omega R_{Pol1} C_{Pol1})^2} \qquad (1)$$

und damit der erste Admittanz-Realteil $G_{\omega_1}$ zu:

$$G_{\omega_1} = \frac{1}{R_{iso}} + \frac{(\omega_1 C_{Pol1})^2 R_{Pol1}}{1 + (\omega_1 R_{Pol1} C_{Pol1})^2} \qquad (2)$$

der erste Admittanz-Imaginärteil $B_{\omega_1}$ zu:

$$B_{\omega_1} = \omega_1 C_{iso} + \frac{\omega_1 C_{Pol1}}{1 + (\omega_1 R_{Pol1} C_{Pol1})^2} \qquad (3)$$

der zweite Admittanz-Realteil $G_{\omega_2}$ zu:

$$G_{\omega_2} = \frac{1}{R_{iso}} + \frac{(\omega_2 C_{Pol1})^2 R_{Pol1}}{1 + (\omega_2 R_{Pol1} C_{Pol1})^2} \qquad (4)$$

sowie der zweite Admittanz-Imaginärteil $B_{\omega_2}$ zu:

$$B_{\omega_2} = \omega_2 C_{iso} + \frac{\omega_2 C_{Pol1}}{1 + (\omega_2 R_{Pol1} C_{Pol1})^2} \qquad (5)$$

wobei $\omega$ allgemein die Kreisfrequenz bezeichnet und $\omega_1$ die sich aus der ersten Frequenz $f_1$ gemäß der Beziehung $\omega_1 = 2\pi \cdot f_1$ errechnende zugehörige Kreisfrequenz und $\omega_2$ die sich aus der zweiten Frequenz $f_2$ gemäß der Beziehung $\omega_2 = 2\pi \cdot f_2$ errechnende zugehörige Kreisfrequenz ist.

Die vier Gleichungen (2) bis (5) liefern nach entsprechender Umformung und Auflösung die vier unbekannten Isolationsparametern $C_{iso}$, $R_{iso}$, $R_{Pol1}$, $C_{Pol1}$. Demnach ergibt sich die Isolationskapazität $C_{iso}$ zu:

$$C_{iso} = \frac{-(B_{w_1} B_{w_2} w_1^2 + (-B_{w_1}^2 - B_{w_2}^2 - G_{w_1}^2 + 2G_{w_1} G_{w_2} - G_{w_2}^2)w_1 w_2 + B_{w1} B_{w2} w_2^2)}{((w_1^2 - w_2^2)(B_{w_1} w_2 - B_{w_2} w_1))} \qquad (6)$$

der Isolationsverlustwiderstand $R_{iso}$ zu:

$$R_{iso} = \frac{-((G_{w_1} - G_{w_2})(w_1^2 - w_2^2))}{(B_{w_1}^2 w_2^2 - 2B_{w_1} B_{w_2} w_1 w_2 + B_{w_2}^2 w_1^2 + G_{w_1}^2 w_2^2 - G_{w_1} G_{w_2} w_1^2 - G_{w_1} G_{w_2} w_2^2 + G_{w_2}^2 w_1^2)} \qquad (7)$$

der erste Polarisationswiderstand $R_{Poll}$ zu:

$$(8)$$

$$R_{pol1} = ((G_{w_1} - G_{w_2})(w_1^2 - w_2^2)(B_{w_1} w_2 - B_{w_2} w_1)^2) /$$

$$((B_{w_1} w_2 - B_{w_2} w_1)^4 + B_{w_1}^2 w_2^2 (w_1^2 + w_2^2)(G_{w_1} - G_{w_2})^2 - 2B_{w_1} B_{w_2} w_1^3 w_2 (G_{w_1} - G_{w_2})^2 -$$

$$2B_{w_1} B_{w_2} w_1 w_2^3 (G_{w_1} - G_{w_2})^2 + B_{w_2}^2 w_1^4 (G_{w_1} - G_{w_2})^2 + B_{w_2}^2 w_1^2 w_2^2 (G_{w_1} - G_{w_2})^2 + w_1^2 w_2^2 (G_{w_1} - G_{w_2})^4)$$

und die erste Polarisationskapazität $C_{Pol1}$ zu:

$$C_{pol1} = \frac{-(((B_{w_1} w_2 - B_{w_2} w_1)^2 + w_1^2 (G_{w_1} - G_{w_2})^2)((B_{w_1} w_2 - B_{w_2} w_1)^2 + w_2^2 (G_{w_1} - G_{w_2})^2))}{(w_1 w_2 (w_1 + w_2)(G_{w_1} - G_{w_2})^2 (B_{w_1} w_2 - B_{w_2} w_1)(w_1 - w_2))} \qquad (9)$$

Durch Einsetzen der vier hochgenauen Messwerte für $G_{\omega1}$, $B_{\omega1}$, $G_{\omega2}$, $B_{\omega2}$ in die Gleichungen (6) bis (9) erhält man die gesuchten Werte für die vier Isolationsparameter $C_{iso}$, $R_{iso}$, $R_{Pol1}$, $C_{Pol1}$. Diese Berechnungsschritte erfolgen insbesondere in der Steuer-/Auswerteeinheit 9. Das Polarisations-Ersatzschaltbild gemäß Fig. 2 ist damit komplett quantifiziert. Es kann für Folgeauswertungen zur Bestimmung des (Isolations-)Zustands des Energieversorgungskabels 2 insbesondere dessen elektrischer Isolation 4 verwendet werden.

Fig. 2 beschreibt ein Ersatzschaltbild, dessen einzelne Elemente und deren Parameter die Ableitung und Beschreibung von Polarisationseffekten innerhalb eines Isoliermediums wie der elektrischen Isolation 4 des Energieversorgungskabels 2 und somit beispielsweise die Unterscheidung von Verlusten aus der Leitfähigkeit und Verlusten aus Polarisationseffekten ermöglicht. Aus diesen Erkenntnissen lassen sich weitergehende Eigenschaften der Isolierung und so auch Alterungserscheinungen ermitteln, die aus der zunehmenden chemischen und physikalischen Veränderung des Isoliermediums resultieren. Hierzu gehört beispielsweise das Eindringen von Wasser in den Isolierstoff. Diese Aspekte lassen sich somit in der Steuer-/Auswerteeinheit 9 unter Verwendung des komplett quantifizierten Polarisations-Ersatzschaltbilds gemäß Fig. 2 bestimmen.

Die Auswertung kann weiter verbessert werden, indem eine weitere hochgenaue komplexe Messung der Impedanz oder der Admittanz bei einer weiteren Frequenz $f_i$ durchgeführt und mit berücksichtigt wird. Dabei unterscheidet sich die weitere Frequenz $f_i$ von den ersten beiden Frequenzen $f_1$, $f_2$. Pro weiterer Messung bei einer weiteren Frequenz $f_i$ kann das Polarisations-Ersatzschaltbild um einen zusätzlichen parallelgeschalteten Zweig aus einer Serienschaltung eines weiteren Polarisationswiderstands und einer weiteren Polarisationskapazität ergänzt werden. In Fig. 3 ist ein auf Grundlage einer dritten Messung um einen Parallelzweig mit einem zweiten Polarisationswiderstand $R_{Pol2}$ und einer zweiten Polarisationskapazität $C_{Pol2}$ erweitertes Polarisations-Ersatzschaltbild gezeigt. Weitere Ergänzungen können analog auf Basis weiterer Messungen bei anderen Frequenzen $f_i$ erfolgen. Anhand solcher erweiterter Polarisations-Ersatzschaltbilder können noch genauere Folgeauswertungen und Analysen zum (Isolations-) Zustand der elektrischen Isolation 4 des Energieversorgungskabels 2 durchgeführt werden.

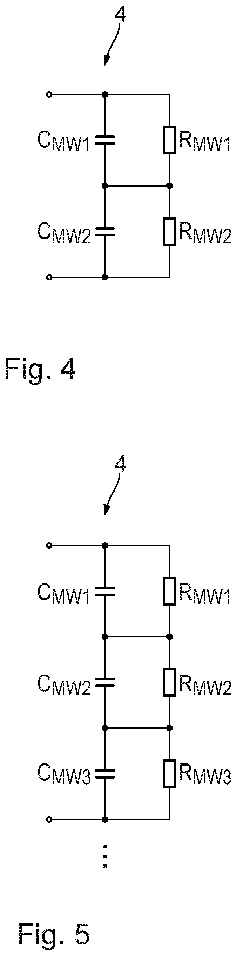

Neben den Polarisations-Ersatzschaltbildern gemäß Fig. 2 und 3 kann für die elektrische Isolation 4 des Energieversorgungskabels 2 auch ein anderes Ersatzschaltbild aufgestellt werden, nämlich das Maxwell-Ersatzschaltbild gemäß Fig. 4. Es hat als Isolationsparameter einen ersten Maxwell-Widerstand $R_{MW1}$, eine erste Maxwell-Kapazität

$C_{MW1}$, einen zweiten Maxwell-Widerstand $R_{MW2}$ und eine zweite Maxwell-Kapazität $C_{MW2}$, wobei gemäß dem Maxwell-Ersatzschaltbild die Parallelschaltung des ersten Maxwell-Widerstands $R_{MW1}$ und der ersten Maxwell-Kapazität $C_{MW1}$ und die Parallelschaltung des zweiten Maxwell-Widerstands $R_{MW2}$ und der zweiten Maxwell-Kapazität $C_{MW2}$ in Reihe geschaltet sind.

Allerdings kann die Ermittlung dieser vier Isolationsparameter $R_{MW1}$, $C_{MW1}$, $R_{MW2}$, $C_{MW2}$ des Maxwell-Ersatzschaltbildes gemäß Fig. 4 nicht auf die gleiche Art und Weise wie bei den vier Isolationsparametern $C_{iso}$, $R_{iso}$, $R_{Pol1}$, $C_{Pol1}$ des Polarisations-Ersatzschaltbildes gemäß Fig. 2 erfolgen. Ein zu den Gleichungen (2) bis (5) vergleichbares Gleichungssystem mit vier Gleichungen für die bei den zwei verschiedenen Frequenzen $f_1$ und $f_2$ bestimmten ersten und zweiten Admittanz-Realteile und Admittanz-Imaginärteile in Abhängigkeit der vier Isolationsparameter $R_{MW1}$, $C_{MW1}$, $R_{MW2}$, $C_{MW2}$ des Maxwell-Ersatzschaltbildes liefert keine eindeutige Lösung.

Stattdessen kann man zunächst das allgemeine Admittanz-Gleichungssystem des Maxwell-Ersatzschaltbildes gemäß Fig. 4 aufstellen und die so erhaltenen vier Gleichungen für die ersten und zweiten Admittanz-Realteile und Admittanz-Imaginärteile mit denen des Polarisations-Ersatzschaltbildes gemäß Fig. 2, also mit den Gleichungen (2) bis (5), gleichsetzen. Dieses Gleichungssystem wird dann zunächst nach den Isolationsparametern $C_{iso}$, $R_{iso}$, $R_{Pol1}$, $C_{Pol1}$ des Polarisations-Ersatzschaltbildes aufgelöst, um die prinzipielle Abhängigkeit zwischen den zwei Schaltungen der beiden Ersatzschaltbilder herzustellen. Ein direktes Auflösen nach den Isolationsparametern $R_{MW1}$, $C_{MW1}$, $R_{MW2}$, $C_{MW2}$ des Maxwell-Ersatzschaltbildes ist hierbei nicht möglich. Die so gewonnenen Gleichungen können dann verwendet werden, um wiederum die Isolationsparameter $R_{MW1}$, $C_{MW1}$, $R_{MW2}$, $C_{MW2}$ des Maxwell-Ersatzschaltbildes in Abhängigkeit der Isolationsparameter $C_{iso}$, $R_{iso}$, $R_{Pol1}$, $C_{Pol1}$ des Polarisations-Ersatzschaltbildes zu berechnen.

Demnach ergibt sich der erste Maxwell-Widerstand $R_{MW1}$ zu:

$$R_{MW1} = (R_{iso}(\sqrt{C_{iso}^2 R_{iso}^2 + 2C_{iso}C_{pol1}R_{iso}^2 - 2C_{iso}C_{pol1}R_{iso}R_{pol1} + C_{pol1}^2 R_{iso}^2 + 2C_{pol1}^2 R_{iso}R_{pol1} + C_{pol1}^2 R_{pol1}^2} +$$
$$C_{iso}R_{iso} + C_{pol1}R_{iso} - C_{pol1}R_{pol1})) /$$
$$(2\sqrt{C_{iso}^2 R_{iso}^2 + 2C_{iso}C_{pol1}R_{iso}^2 - 2C_{iso}C_{pol1}R_{iso}R_{pol1} + C_{pol1}^2 R_{iso}^2 + 2C_{pol1}^2 R_{iso}R_{pol1} + C_{pol1}^2 R_{pol1}^2})$$

$$(10)$$

die erste Maxwell-Kapazität $C_{MW1}$ zu:

$$C_{MW1} = (C_{iso}^2 R_{iso}^2 + 2C_{iso}C_{pol1}R_{iso}^2 - 2C_{iso}C_{pol1}R_{iso}R_{pol1} -$$
$$\sqrt{(C_{iso}^2 R_{iso}^2 + 2C_{iso}C_{pol1}R_{iso}^2 - 2C_{iso}C_{pol1}R_{iso}R_{pol1} + C_{pol1}^2 R_{iso}^2 + 2C_{pol1}^2 R_{iso}R_{pol1} + C_{pol1}^2 R_{pol1}^2)} \cdot$$
$$C_{iso}R_{iso} + C_{pol1}^2 R_{iso}^2 + 2C_{pol1}^2 R_{iso}R_{pol1} + C_{pol1}^2 R_{pol1}^2) / (2C_{pol1}R_{iso}^2) +$$
$$(\sqrt{(C_{iso}^2 R_{iso}^2 + 2C_{iso}C_{pol1}R_{iso}^2 - 2C_{iso}C_{pol1}R_{iso}R_{pol1} + C_{pol1}^2 R_{iso}^2 + 2C_{pol1}^2 R_{iso}R_{pol1} + C_{pol1}^2 R_{pol1}^2)} \cdot$$
$$(R_{iso} + R_{pol1})) / (2R_{iso}^2)$$

$$(11)$$

der zweite Maxwell-Widerstand $R_{MW2}$ zu:

$$R_{MW2} = (R_{iso}(\sqrt{C_{iso}^2 R_{iso}^2 + 2C_{iso}C_{pol1}R_{iso}^2 - 2C_{iso}C_{pol1}R_{iso}R_{pol1} + C_{pol1}^2 R_{iso}^2 + 2C_{pol1}^2 R_{iso}R_{pol1} + C_{pol1}^2 R_{pol1}^2} -$$
$$C_{iso}R_{iso} - C_{pol1}R_{iso} + C_{pol1}R_{pol1})) /$$
$$(2\sqrt{C_{iso}^2 R_{iso}^2 + 2C_{iso}C_{pol1}R_{iso}^2 - 2C_{iso}C_{pol1}R_{iso}R_{pol1} + C_{pol1}^2 R_{iso}^2 + 2C_{pol1}^2 R_{iso}R_{pol1} + C_{pol1}^2 R_{pol1}^2})$$

$$(12)$$

und die zweite Maxwell-Kapazität $C_{MW2}$ zu:

$$C_{MW2} = (C_{iso}^2 R_{iso}^2 + 2C_{iso}C_{pol1}R_{iso}^2 - 2C_{iso}C_{pol1}R_{iso}R_{pol1} +$$

$$\overline{\sqrt{C_{iso}^2 R_{iso}^2 + 2C_{iso}C_{pol1}R_{iso}^2 - 2C_{iso}C_{pol1}R_{iso}R_{pol1} + C_{pol1}^2 R_{iso}^2 + 2C_{pol1}^2 R_{iso}R_{pol1} + C_{pol1}^2 R_{pol1}^2}} \cdot$$

$$C_{iso}R_{iso} + C_{pol1}^2 R_{iso}^2 + 2C_{pol1}^2 R_{iso}R_{pol1} + C_{pol1}^2 R_{pol1}^2) / (2C_{pol1}R_{iso}^2) -$$

$$(\overline{\sqrt{C_{iso}^2 R_{iso}^2 + 2C_{iso}C_{pol1}R_{iso}^2 - 2C_{iso}C_{pol1}R_{iso}R_{pol1} + C_{pol1}^2 R_{iso}^2 + 2C_{pol1}^2 R_{iso}R_{pol1} + C_{pol1}^2 R_{pol1}^2}} \cdot$$

$$(R_{iso} + R_{pol1})) / (2R_{iso}^2)$$

$$(13)$$

Unter Berücksichtigung der Lösungsgleichungen (6) bis (9) für die Isolationsparameter $C_{iso}$, $R_{iso}$, $R_{Pol1}$, $C_{Pol1}$ des Polarisations-Ersatzschaltbildes können somit auch die Isolationsparameter $R_{MW1}$, $C_{MW1}$, $R_{MW2}$, $C_{MW2}$ des Maxwell-Ersatzschaltbildes über mehrere Schritte indirekt aus den vier hochgenauen Messwerten für $G_{\omega1}$, $B_{\omega1}$, $G_{\omega2}$, $B_{\omega2}$ analytisch berechnet werden. Auch hier erfolgen die Berechnungsschritte insbesondere in der Steuer-/Auswerteeinheit 9.

Letztendlich ist auch das Maxwell-Ersatzschaltbild gemäß Fig. 4 komplett quantifiziert. Es kann ebenso für Folgeauswertungen zur Bestimmung des (Isolations-)Zustands des Energieversorgungskabels 2 insbesondere dessen elektrischer Isolation 4 verwendet werden.

Das Maxwell-Ersatzschaltbild gemäß Fig. 4 lässt sich insbesondere mit Vorteil bei der Diagnose geschichteter Dielektrika (z.B. Papier-Öl-Dielektrika bzw. Papier-Masse-Dielektrika oder auch mit Leitschichten versehenen Kunststoffisolierungen) und somit z.B. bei Rückkehrspannungsmessungen verwenden. Die Isolationsparameter $R_{MW1}$, $C_{MW1}$, $R_{MW2}$, $C_{MW2}$ des Maxwell-Ersatzschaltbildes können allerdings aus den Ergebnissen von Rückkehrspannungsmessungen oder auch anderen gleichspannungsbasierten Messverfahren nicht vollständig abgeleitet werden. Mittels des hier vorgestellten Verfahrens kann der direkt vorhandene Zusammenhang verwendet werden, um aus den vollständig bestimmbaren Isolationsparametern $R_{MW1}$, $C_{MW1}$, $R_{MW2}$, $C_{MW2}$ rechnerisch den exakten Verlauf der Rückkehrspannung und die bei der Interpretation von Rückkehrspannungsmessung verwendeten, diese beschreibenden Kenngrößen zu ermitteln. Hieraus können zudem weitere und bereits im Bereich der Rückkehrspannungsmessung etablierte Diagnoseparameter, wie z.B. der p-Faktor numerisch berechnet werden und somit die Korrelation mit bekannten (jedoch häufig nur aufwändig zu gewinnenden) Diagnosekriterien hergestellt werden.

Auch die Auswertung anhand des Maxwell-Ersatzschaltbildes kann weiter verbessert werden, indem eine weitere hochgenaue komplexe Messung der Impedanz oder der Admittanz bei einer weiteren Frequenz $f_i$ durchgeführt und mit berücksichtigt wird. Wiederum unterscheidet sich die weitere Frequenz $f_i$ von den ersten beiden Frequenzen $f_1$, $f_2$. Pro weiterer Messung bei einer weiteren Frequenz $f_i$ kann das Maxwell-Ersatzschaltbild um eine zusätzliche in Serie geschaltete Parallelschaltung eines weiteren Maxwell-Widerstands $R_{MWi}$ und einer weiteren Maxwell-Kapazität $C_{MWi}$ ergänzt werden. In Fig. 5 ist ein auf Grundlage einer dritten Messung um einen dritten Maxwell-Widerstand $R_{MW3}$ und eine dritte Maxwell-Kapazität $C_{MW3}$ erweitertes Maxwell-Ersatzschaltbild gezeigt. Weitere Ergänzungen können analog auf Basis weiterer Messungen bei anderen Frequenzen $f_i$ erfolgen. Anhand solcher erweiterter Maxwell-Ersatzschaltbilder können noch genauere Folgeauswertungen und Analysen zum (Isolations-) Zustand der elektrischen Isolation 4 des Energieversorgungskabels 2 durchgeführt werden.

## Patentansprüche

1. Verfahren zum Erfassen von Isolationsparametern einer elektrischen Isolation (4) eines Energieversorgungs-Betriebsmittels (2), das einen ersten und einen zweiten elektrischen Leiter (3, 5) hat, die mittels der elektrischen Isolation (4) gegeneinander elektrisch isoliert sind, wobei

a) anhand einer bei einer ersten Frequenz ($f_1$) durchgeführten ersten Messung am Energieversorgungs-Betriebsmittel (2) zwei erste reelle Immitanz-Anteile einer zwischen dem ersten und dem zweiten Leiter (3, 5) liegenden ersten komplexen Immitanz ($\underline{Y}$) ermittelt werden,
b) und mindestens anhand einer bei einer von der ersten Frequenz ($f_1$) verschiedenen zweiten Frequenz ($f_2$) durchgeführten zweiten Messung am Energieversorgungs-Betriebsmittel (2) zwei zweite reelle Immitanz-Anteile einer zweiten komplexen Immitanz ($\underline{Y}$) ermittelt werden,
c) anhand der zwei ersten reellen Immitanz-Anteile und der zwei zweiten reellen Immitanz-Anteile vier erste Isolationsparameter der elektrischen Isolation (4) gemäß einem Polarisations-Ersatzschaltbild in Form einer parallelen Isolationskapazität ($C_{iso}$), eines parallelen Isolationsverlustwiderstands ($R_{iso}$), eines ersten Polarisa-

tionswiderstands ($R_{Pol1}$) und einer ersten Polarisationskapazität ($C_{Pol1}$) bestimmt werden, wobei gemäß dem Polarisations-Ersatzschaltbild die Isolationskapazität ($C_{iso}$), der Isolationsverlustwiderstand ($R_{iso}$) sowie die Serienschaltung des ersten Polarisationswiderstands ($R_{Pol1}$) und der ersten Polarisationskapazität ($C_{Pol1}$) parallel zueinander geschaltet sind.

2. Verfahren nach Anspruch 1, **dadurch gekennzeichnet, dass** sich die erste Frequenz ($f_1$) und die zweite Frequenz ($f_2$) um einen Faktor von mindestens 2 und vorzugsweise um einen Faktor von mindestens 10 voneinander unterscheiden.

3. Verfahren nach Anspruch 1 oder 2, **dadurch gekennzeichnet, dass** die erste Frequenz ($f_1$) im Bereich zwischen 0,01 Hz und 1 Hz liegt.

4. Verfahren nach einem der vorherigen Ansprüche, **dadurch gekennzeichnet, dass** die zweite Frequenz ($f_2$) eine Netzfrequenz, insbesondere 50 Hz oder 60 Hz, ist.

5. Verfahren nach einem der vorherigen Ansprüche, **dadurch gekennzeichnet, dass** die beiden Messungen mit unterschiedlicher Prüfspannung eines angelegten Prüfsignals ($PS_1$, $PS_2$) durchgeführt werden.

6. Verfahren nach einem der vorherigen Ansprüche, **dadurch gekennzeichnet, dass** die zwei ersten reellen Immitanz-Anteile ein erster Admittanz-Realteil $G_{\omega 1}$ und ein erster Admittanz-Imaginärteil $B_{\omega 1}$ sind und die zwei zweiten reellen Immitanz-Anteile ein zweiter Admittanz-Realteil $G_{\omega 2}$ und ein zweiter Admittanz-Imaginärteil $B_{\omega 2}$ sind, und die Isolationskapazität $C_{iso}$ gemäß:

$$C_{iso} = \frac{-(B_{w_1} B_{w_2} w_1^2 + (-B_{w_1}^2 - B_{w_2}^2 - G_{w_1}^2 + 2 G_{w_1} G_{w_2} - G_{w_2}^2) w_1 w_2 + B_{w_1} B_{w_2} w_2^2)}{((w_1^2 - w_2^2)(B_{w_1} w_2 - B_{w_2} w_1))}$$

der Isolationsverlustwiderstand $R_{iso}$ gemäß:

$$R_{iso} = \frac{-((G_{w_1} - G_{w_2})(w_1^2 - w_2^2))}{(B_{w_1}^2 w_2^2 - 2 B_{w_1} B_{w_2} w_1 w_2 + B_{w_2}^2 w_1^2 + G_{w_1}^2 w_2^2 - G_{w_1} G_{w_2} w_1^2 - G_{w_1} G_{w_2} w_2^2 + G_{w_2}^2 w_1^2)}$$

der erste Polarisationswiderstand $R_{Pol1}$ gemäß:

$$R_{pol1} = ((G_{w_1} - G_{w_2})(w_1^2 - w_2^2)(B_{w_1} w_2 - B_{w_2} w_1)^2) /$$
$$((B_{w_1} w_2 - B_{w_2} w_1)^4 + B_{w_1}^2 w_2^2 (w_1^2 + w_2^2)(G_{w_1} - G_{w_2})^2 - 2 B_{w_1} B_{w_2} w_1^3 w_2 (G_{w_1} - G_{w_2})^2 -$$
$$2 B_{w_1} B_{w_2} w_1 w_2^3 (G_{w_1} - G_{w_2})^2 + B_{w_2}^2 w_1^4 (G_{w_1} - G_{w_2})^2 + B_{w_2}^2 w_1^2 w_2^2 (G_{w_1} - G_{w_2})^2 + w_1^2 w_2^2 (G_{w_1} - G_{w_2})^4)$$

und die erste Polarisationskapazität $C_{Pol1}$ gemäß:

$$C_{pol1} = \frac{-(((B_{w_1} w_2 - B_{w_2} w_1)^2 + w_1^2 (G_{w_1} - G_{w_2})^2)((B_{w_1} w_2 - B_{w_2} w_1)^2 + w_2^2 (G_{w_1} - G_{w_2})^2))}{(w_1 w_2 (w_1 + w_2)(G_{w_1} - G_{w_2})^2 (B_{w_1} w_2 - B_{w_2} w_1)(w_1 - w_2))}$$

bestimmt wird, wobei $\omega_1$ die zur ersten Frequenz gehörige Kreisfrequenz und $\omega_2$ die zur zweiten Frequenz gehörige Kreisfrequenz ist.

7. Verfahren nach einem der vorherigen Ansprüche, **dadurch gekennzeichnet, dass** anhand mindestens einer bei einer von der ersten und der zweiten Frequenz ($f_1$, $f_2$) verschiedenen weiteren Frequenz durchgeführten weiteren Messung am Energieversorgungs-Betriebsmittel (2) pro weiterer Messung zwei weitere reelle Immitanz-Anteile einer weiteren komplexen Immitanz ermittelt werden, und pro weiterer Messung anhand der ersten und zweiten reellen Immitanz-Anteile gemäß einem weiteren Polarisations-Ersatzschaltbild jeweils zwei weitere erste Isolationsparameter der elektrischen Isolation in Form eines weiteren Polarisationswiderstands ($R_{Pol2}$) und einer weiteren Polarisationskapazität ($C_{Pol2}$) bestimmt werden, wobei die Serienschaltung des weiteren Polarisationswiderstands ($R_{Pol2}$) und der weiteren Polarisationskapazität ($C_{Pol2}$) gemäß dem weiteren Polarisations-Ersatzschaltbild parallel zu der Isolationskapazität ($C_{iso}$), zu dem Isolationsverlustwiderstand ($R_{iso}$) sowie zu der Serienschaltung des ersten Polarisationswiderstands ($R_{Pol1}$) und der ersten Polarisationskapazität ($C_{Pol1}$) geschaltet ist.

8. Verfahren nach einem der vorherigen Ansprüche, **dadurch gekennzeichnet, dass** anhand der Isolationskapazität ($C_{iso}$), des Isolationsverlustwiderstands ($R_{iso}$), des ersten Polarisationswiderstands ($R_{Pol1}$) und der ersten Polarisationskapazität ($C_{Pol1}$) gemäß dem Polarisations-Ersatzschaltbild vier zweite Isolationsparameter der elektrischen Isolation gemäß einem Maxwell-Ersatzschaltbild und in Form eines ersten Maxwell-Widerstands ($R_{MW1}$), einer ersten Maxwell-Kapazität ($C_{MW1}$), eines zweiten Maxwell-Widerstands ($R_{MW2}$) und einer zweiten Maxwell-Kapazität ($C_{MW2}$) bestimmt werden, wobei gemäß dem Maxwell-Ersatzschaltbild die Parallelschaltung des ersten Maxwell-Widerstands ($R_{MW1}$) und der ersten Maxwell-Kapazität ($C_{MW1}$) und die Parallelschaltung des zweiten Maxwell-Widerstands ($R_{MW2}$) und der zweiten Maxwell-Kapazität ($C_{MW2}$) in Reihe geschaltet sind.

9. Verfahren nach einem der vorherigen Ansprüche, **dadurch gekennzeichnet, dass** anhand der bestimmten Isolationsparameter entweder unmittelbar oder mittelbar nach Durchführung von Folgeberechnungen unter Verwendung der Isolationsparameter das Isolationsverhalten des Energieversorgungs-Betriebsmittels (2), insbesondere mindestens eine der Größen aus volumen- oder massebezogener Wasseranteil der elektrischen Isolation (4), Trockenmasseanteil der elektrischen Isolation (4), Alterungszustand der elektrischen Isolation (4) und Restlebensdauer der elektrischen Isolation (4), ermittelt wird.

10. Vorrichtung zum Erfassen von Isolationsparametern einer elektrischen Isolation (4) eines Energieversorgungs-Betriebsmittels (2), das einen ersten und einen zweiten elektrischen Leiter (3, 5) hat, die mittels der elektrischen Isolation (4) gegeneinander elektrisch isoliert sind, aufweisend

a) eine Quelleinheit (6) zur Erzeugung eines ersten Prüfsignals ($PS_1$) mit einer ersten Frequenz ($f_1$) und mindestens eines zweiten Prüfsignals ($PS_2$) mit einer von der ersten Frequenz ($f_1$) verschiedenen zweiten Frequenz ($f_2$),
b) eine Messeinheit (7) die dazu ausgelegt ist, das erste Prüfsignal ($PS_1$) im Rahmen einer ersten Messung und das zweite Prüfsignal ($PS_2$) im Rahmen einer zweiten Messung an das Energieversorgungs-Betriebsmittel (2) anzulegen, und
c) eine mit der Quelleinheit (6) und der Messeinheit (7) datentechnisch in Verbindung stehende Steuer-/Auswerteeinheit (9),
d) wobei die Messeinheit (7) oder die Steuer-/Auswerteeinheit (9) dazu ausgelegt ist,

d1) anhand der ersten Messung zwei erste reelle Immitanz-Anteile einer zwischen dem ersten und dem zweiten Leiter (3, 5) des Energieversorgungs-Betriebsmittels (2) liegenden ersten komplexen Immitanz ($\underline{Y}$) zu ermitteln, und
d2) anhand der zweiten Messung zwei zweite reelle Immitanz-Anteile einer zwischen dem ersten und dem zweiten Leiter (3, 5) des Energieversorgungs-Betriebsmittels (2) liegenden zweiten komplexen Immitanz ($\underline{Y}$) zu ermitteln,

e) wobei die Steuer-/Auswerteeinheit (9) weiterhin dazu ausgelegt ist, anhand der zwei ersten reellen Immitanz-Anteile und der zwei zweiten reellen Immitanz-Anteile vier erste Isolationsparameter der elektrischen Isolation gemäß einem Polarisations-Ersatzschaltbild in Form einer parallelen Isolationskapazität ($C_{iso}$), eines parallelen Isolationsverlustwiderstands ($R_{iso}$), eines ersten Polarisationswiderstands ($R_{Pol1}$) und einer ersten Polarisationskapazität ($C_{Pol1}$) zu bestimmen, wobei gemäß dem Polarisations-Ersatzschaltbild die Isolationskapazität ($C_{iso}$), der Isolationsverlustwiderstand ($R_{iso}$) sowie die Serienschaltung des ersten Polarisationswiderstands ($R_{Pol1}$) und der ersten Polarisationskapazität ($C_{Pol1}$) parallel zueinander geschaltet sind.

11. Vorrichtung nach Anspruch 10, **dadurch gekennzeichnet, dass** sich die erste Frequenz ($f_1$) und die zweite Frequenz ($f_2$) um einen Faktor von mindestens 2 und vorzugsweise um einen Faktor von mindestens 10 voneinander unterscheiden.

12. Vorrichtung nach Anspruch 10 oder 11, **dadurch gekennzeichnet, dass** die erste Frequenz ($f_1$) im Bereich zwischen 0,01 Hz und 1 Hz liegt.

**13.** Vorrichtung nach einem der Ansprüche 10 bis 12, **dadurch gekennzeichnet, dass** ein die zweite Frequenz ($f_2$) eine Netzfrequenz, insbesondere 50 Hz oder 60 Hz, ist.

**14.** Vorrichtung nach einem der Ansprüche 10 bis 13, **dadurch gekennzeichnet, dass** die Quelleinheit (6) dazu ausgelegt ist, das erste und das zweite Prüfsignal ($PS_1$, $PS_2$) mit jeweils unterschiedlicher Prüfspannung zu erzeugen.

**15.** Vorrichtung nach einem der Ansprüche 10 bis 14, **dadurch gekennzeichnet, dass** die zwei ersten reellen Immitanz-Anteile ein erster Admittanz-Realteil $G_{\omega 1}$ und ein erster Admittanz-Imaginärteil $B_{\omega 1}$ sind und die zwei zweiten reellen Immitanz-Anteile ein zweiter Admittanz-Realteil $G_{\omega 2}$ und ein zweiter Admittanz-Imaginärteil $B_{\omega 2}$ sind, und die Steuer-/Auswerteeinheit (9) dazu ausgelegt ist, die Isolationskapazität $C_{iso}$ gemäß:

$$C_{iso} = \frac{-(B_{w_1} B_{w_2} w_1^2 + (-B_{w_1}^2 - B_{w_2}^2 - G_{w_1}^2 + 2G_{w_1} G_{w_2} - G_{w_2}^2)w_1 w_2 + B_{w_1} B_{w_2} w_2^2)}{((w_1^2 - w_2^2)(B_{w_1} w_2 - B_{w_2} w_1))},$$

den Isolationsverlustwiderstand $R_{iso}$ gemäß:

$$R_{iso} = \frac{-((G_{w_1} - G_{w_2})(w_1^2 - w_2^2))}{(B_{w_1}^2 w_2^2 - 2B_{w_1} B_{w_2} w_1 w_2 + B_{w_2}^2 w_1^2 + G_{w_1}^2 w_2^2 - G_{w_1} G_{w_2} w_1^2 - G_{w_1} G_{w_2} w_2^2 + G_{w_2}^2 w_1^2)},$$

den ersten Polarisationswiderstand $R_{Pol1}$ gemäß:

$$R_{pol1} = ((G_{w_1} - G_{w_2})(w_1^2 - w_2^2)(B_{w_1} w_2 - B_{w_2} w_1)^2) /$$
$$((B_{w_1} w_2 - B_{w_2} w_1)^4 + B_{w_1}^2 w_2^2 (w_1^2 + w_2^2)(G_{w_1} - G_{w_2})^2 - 2B_{w_1} B_{w_2} w_1^3 w_2 (G_{w_1} - G_{w_2})^2 -$$
$$2B_{w_1} B_{w_2} w_1 w_2^3 (G_{w_1} - G_{w_2})^2 + B_{w_2}^2 w_1^4 (G_{w_1} - G_{w_2})^2 + B_{w_2}^2 w_1^2 w_2^2 (G_{w_1} - G_{w_2})^2 + w_1^2 w_2^2 (G_{w_1} - G_{w_2})^4)$$

und die erste Polarisationskapazität $C_{Pol1}$ gemäß:

$$C_{pol1} = \frac{-(((B_{w_1} w_2 - B_{w_2} w_1)^2 + w_1^2 (G_{w_1} - G_{w_2})^2)((B_{w_1} w_2 - B_{w_2} w_1)^2 + w_2^2 (G_{w_1} - G_{w_2})^2))}{(w_1 w_2 (w_1 + w_2)(G_{w_1} - G_{w_2})^2 (B_{w_1} w_2 - B_{w_2} w_1)(w_1 - w_2))}$$

zu bestimmen, wobei $\omega_1$ die zur ersten Frequenz gehörige Kreisfrequenz und $\omega_2$ die zur zweiten Frequenz gehörige Kreisfrequenz ist.

**16.** Vorrichtung nach einem der Ansprüche 10 bis 15, **dadurch gekennzeichnet, dass** die Quelleinheit (6) dazu ausgelegt ist, mindestens ein weiteres Prüfsignal mit einer von der ersten und der zweiten Frequenz ($f_1$, $f_2$) verschiedenen weiteren Frequenz zu erzeugen, die Messeinheit (7) dazu ausgelegt ist, das mindestens eine weitere Prüfsignal im Rahmen mindestens einer weiteren Messung an das Energieversorgungs-Betriebsmittel (2) anzulegen, die Messeinheit (6) oder die Steuer-/Auswerteeinheit (9) dazu ausgelegt ist, anhand pro weiterer Messung zwei weitere reelle Immitanz-Anteile mindestens einer zwischen dem ersten und dem zweiten Leiter (3, 5) des Energieversorgungs-Betriebsmittels (2) liegenden weiteren komplexen Immitanz ($\underline{Y}$) zu ermitteln, und die Steuer-/Auswerteeinheit (9) weiterhin dazu ausgelegt ist, pro weiterer Messung anhand der ersten und zweiten reellen Immitanz-Anteile gemäß einem weiteren Polarisations-Ersatzschaltbild jeweils zwei weitere erste Isolationsparameter der elektrischen Isolation in Form eines weiteren Polarisationswiderstands ($R_{Pol2}$) und einer weiteren Polarisationskapazität ($C_{Pol2}$) zu bestimmen, wobei die Serienschaltung des weiteren Polarisationswiderstands ($R_{Pol2}$) und der weiteren Polarisationskapazität ($C_{Pol2}$) gemäß dem weiteren Polarisations-Ersatzschaltbild parallel zu der Isolationskapazität ($C_{iso}$), zu dem Isolationsverlustwiderstand ($R_{iso}$) sowie zu der Serienschaltung des ersten Polarisationswiderstands ($R_{Pol1}$) und der ersten Polarisationskapazität ($C_{Pol1}$) geschaltet ist.

**17.** Vorrichtung nach einem der Ansprüche 10 bis 16, **dadurch gekennzeichnet, dass** die Steuer-/Auswerteeinheit (9) dazu ausgelegt ist, anhand der Isolationskapazität (C$_{iso}$), des Isolationsverlustwiderstands (R$_{iso}$), des ersten Polarisationswiderstands (R$_{Pol1}$) und der ersten Polarisationskapazität (C$_{Pol1}$) gemäß dem Polarisations-Ersatzschaltbild vier zweite Isolationsparameter der elektrischen Isolation gemäß einem Maxwell-Ersatzschaltbild und in Form eines ersten Maxwell-Widerstands (R$_{MW1}$), einer ersten Maxwell-Kapazität (C$_{MW1}$), eines zweiten Maxwell-Widerstands (R$_{MW2}$) und einer zweiten Maxwell-Kapazität (C$_{MW2}$) zu bestimmen, wobei gemäß dem Maxwell-Ersatzschaltbild die Parallelschaltung des ersten Maxwell-Widerstands (R$_{MW1}$) und der ersten Maxwell-Kapazität (C$_{MW1}$) und die Parallelschaltung des zweiten Maxwell-Widerstands (R$_{MW2}$) und der zweiten Maxwell-Kapazität (C$_{MW2}$) in Reihe geschaltet sind.

18. Vorrichtung nach einem der Ansprüche 10 bis 17, **dadurch gekennzeichnet, dass** die Steuer-/Auswerteeinheit (9) dazu ausgelegt ist, anhand der bestimmten Isolationsparameter entweder unmittelbar oder mittelbar nach Durchführung von Folgeberechnungen unter Verwendung der Isolationsparameter das Isolationsverhalten des Energieversorgungs-Betriebsmittels (2), insbesondere mindestens eine der Größen aus volumen- oder massebezogener Wasseranteil der elektrischen Isolation (4), Trockenmasseanteil der elektrischen Isolation (4), Alterungszustand der elektrischen Isolation (4) und Restlebensdauer der elektrischen Isolation (4), zu ermitteln.

## Claims

1. Method for capturing insulation parameters of an electrical insulation (4) of power supply equipment (2) having a first and a second electrical conductor (3, 5), which are electrically insulated from one another by means of the electrical insulation (4), wherein

   a) two first real immittance components of a first complex immittance ($\underline{Y}$) lying between the first and the second conductor (3, 5) are ascertained on the basis of a first measurement on the power supply equipment (2) carried out at a first frequency (f$_1$)
   b) and at least two second real immittance components of a second complex immittance ($\underline{Y}$) are ascertained on the basis of a second measurement on the power supply equipment (2) carried out at a second frequency (f$_2$) that differs from the first frequency (f$_1$),
   c) the two first real immittance components and the two second real immittance components are used to determine four first insulation parameters of the electrical insulation (4) in accordance with a polarization equivalent circuit diagram, in the form of a parallel insulation capacitance (C$_{iso}$), a parallel insulation loss resistance (R$_{iso}$), a first polarization resistance (R$_{Pol1}$) and a first polarization capacitance (C$_{Pol1}$), wherein, in accordance with the polarization equivalent circuit diagram, the insulation capacitance (C$_{iso}$), the insulation loss resistance (R$_{iso}$) and the series connection of the first polarization resistance (R$_{Pol1}$) and the first polarization capacitance (C$_{Pol1}$) are connected in parallel.

2. Method according to Claim 1, **characterized in that** the first frequency (f$_1$) and the second frequency (f$_2$) differ from one another by a factor of at least 2 and preferably by a factor of at least 10.

3. Method according to Claim 1 or 2, **characterized in that** the first frequency (f$_1$) lies in the range between 0.01 Hz and 1 Hz.

4. Method according to any one of the preceding claims, **characterized in that** the second frequency (f$_2$) is a power-line frequency, in particular 50 Hz or 60 Hz.

5. Method according to any one of the preceding claims, **characterized in that** the two measurements are carried out with different test voltages of an applied test signal (PS$_1$, PS$_2$).

6. Method according to any one of the preceding claims, **characterized in that** the two first real immittance components are a first real part of the admittance $G_{\omega_1}$ and a first imaginary part of the admittance $B_{\omega_1}$ and the two second real immittance components are a second real part of the admittance $G_{\omega_2}$ and a second imaginary part of the admittance $B_{\omega_2}$, and the insulation capacitance C$_{iso}$ is determined according to:

$$C_{iso} = \frac{-\left(B_{\omega_1} B_{\omega_2} \omega_1^2 + \left(-B_{\omega_1}^2 - B_{\omega_2}^2 - G_{\omega_1}^2 + 2 G_{\omega_1} G_{\omega_2} - G_{\omega_2}^2\right)\omega_1 \omega_2 + B_{\omega_1} B_{\omega_2} \omega_2^2\right)}{\left((\omega_1^2 - \omega_2^2)(B_{\omega_1}\omega_2 - B_{\omega_2}\omega_1)\right)}$$

the insulation loss resistance $R_{iso}$ is determined according to:

$$R_{iso} = \frac{-\left(\left(G_{\omega_1} - G_{\omega_2}\right)\left(\omega_1^2 - \omega_2^2\right)\right)}{\left(B_{\omega_1}^2\omega_2^2 - 2B_{\omega_1}B_{\omega_2}\omega_1\omega_2 + B_{\omega_2}^2\omega_1^2 + G_{\omega_1}^2\omega_2^2 - G_{\omega_1}G_{\omega_2}\omega_1^2 - G_{\omega_1}G_{\omega_2}\omega_2^2 + G_{\omega_2}^2\omega_1^2\right)}$$

the first polarization resistance $R_{Pol1}$ is determined according to:

$$R_{pol1} = \left(\left(G_{\omega_1} - G_{\omega_2}\right)\left(\omega_1^2 - \omega_2^2\right)\left(B_{\omega_1}\omega_2 - B_{\omega_2}\omega_1\right)^2\right) /$$

$$\left(\left(B_{\omega_1}\omega_2 - B_{\omega_2}\omega_1\right)^4 + B_{\omega_1}^2\omega_2^2\left(\omega_1^2 + \omega_2^2\right)\left(G_{\omega_1} - G_{\omega_2}\right)^2 - 2B_{\omega_1}B_{\omega_2}\omega_1^3\omega_2\left(G_{\omega_1} - G_{\omega_2}\right)^2\right.$$

$$- 2B_{\omega_1}B_{\omega_2}\omega_1\omega_2^3\left(G_{\omega_1} - G_{\omega_2}\right)^2 + B_{\omega_2}^2\omega_1^4\left(G_{\omega_1} - G_{\omega_2}\right)^2 + B_{\omega_2}^2\omega_1^2\omega_2^2\left(G_{\omega_1} - G_{\omega_2}\right)^2$$

$$\left. + \omega_1^2\omega_2^2\left(G_{\omega_1} - G_{\omega_2}\right)^4\right)$$

and the first polarization capacitance $C_{Pol1}$ is determined according to:

$$C_{pol1} = \frac{-\left(\left(\left(B_{\omega_1}\omega_2 - B_{\omega_2}\omega_1\right)^2 + \omega_1^2\left(G_{\omega_1} - G_{\omega_2}\right)^2\right)\left(\left(B_{\omega_1}\omega_2 - B_{\omega_2}\omega_1\right)^2 + \omega_2^2\left(\left(G_{\omega_1} - G_{\omega_2}\right)\right)^2\right)\right)}{\left(\omega_1\omega_2(\omega_1 + \omega_2)\left(G_{\omega_1} - G_{\omega_2}\right)^2\left(B_{\omega_1}\omega_2 - B_{\omega_2}\omega_1\right)(\omega_1 - \omega_2)\right)}$$

where $\omega_1$ is the angular frequency belonging to the first frequency and $\omega_2$ is the angular frequency belonging to the second frequency.

7. Method according to any one of the preceding claims, **characterized in that** at least one further measurement on the power supply equipment (2), carried out at a further frequency that differs from the first and second frequency ($f_1$, $f_2$), is used to ascertain two further real immittance components of a further complex immittance per further measurement and the first and the second real immittance components in accordance with a further polarization equivalent circuit diagram are used to respectively determine two further first insulation parameters of the electrical insulation per further measurement in the form of a further polarization resistance ($R_{Pol2}$) and a further polarization capacitance ($C_{Pol2}$), wherein the series connection of the further polarization resistance ($R_{Pol2}$) and the further polarization capacitance ($C_{Pol2}$) in accordance with the further polarization equivalent circuit diagram is connected parallel to the insulation capacitance ($C_{iso}$), the insulation loss resistance ($R_{iso}$) and the series connection of the first polarization resistance ($R_{Pol1}$) and the first polarization capacitance ($C_{Pol1}$).

8. Method according to any one of the preceding claims, **characterized in that** four second insulation parameters of the electrical insulation are determined in accordance with a Maxwell equivalent circuit diagram and in the form of a first Maxwell resistance ($R_{MW1}$), a first Maxwell capacitance ($C_{MW1}$), a second Maxwell resistance ($R_{MW2}$) and a second Maxwell capacitance ($C_{MW2}$) on the basis of the insulation capacitance ($C_{iso}$), the insulation loss resistance ($R_{iso}$), the first polarization resistance ($R_{Pol1}$) and the first polarization capacitance ($C_{Pol1}$) in accordance with the polarization equivalent circuit diagram, wherein, in accordance with the Maxwell equivalent circuit diagram, the parallel connection of the first Maxwell resistance ($R_{MW1}$) and the first Maxwell capacitance ($C_{MW1}$) and the parallel connection of the second Maxwell resistance ($R_{MW2}$) and the second Maxwell capacitance ($C_{MW2}$) are series connected.

9. Method according to any one of the preceding claims, **characterized in that** the determined insulation parameters are used to ascertain, either directly or indirectly after carrying out subsequent calculations using the insulation parameters, the insulation behaviour of the power supply equipment (2), in particular at least one of the variables of volume-related or mass-related water content of the electrical insulation (4), dry mass component of the electrical insulation (4), ageing state of the electrical insulation (4) and residual service life of the electrical insulation (4).

10. Apparatus for capturing insulation parameters of an electrical insulation (4) of power supply equipment (2) having a first and a second electrical conductor (3, 5), which are electrically insulated from one another by means of the electrical insulation (4), comprising

a) a source unit (6) for generating a first test signal ($PS_1$) at a first frequency ($f_1$) and at least one second test

signal (PS$_2$) at a second frequency (f$_2$) that differs from the first frequency (f$_1$),

b) a measuring unit (7) which is designed to apply the first test signal (PS$_1$) within the scope of a first measurement and the second test signal (PS$_2$) within the scope of a second measurement, in each case to the power supply equipment (2), and

c) a control/evaluation unit (9) which is data-connected to the source unit (6) and the measuring unit (7),

d) wherein the measuring unit (7) or the control/evaluation unit (9) is designed to

d1) ascertain two first real immittance components of a first complex immittance ($\underline{Y}$) lying between the first and the second conductor (3, 5) of the power supply equipment (2) on the basis of the first measurement, and

d2) ascertain two second real immittance components of a second complex immittance ($\underline{Y}$) lying between the first and the second conductor (3, 5) of the power supply equipment (2) on the basis of the second measurement,

e) wherein the control/evaluation unit (9) is further designed to use the two first real immittance components and the two second real immittance components to determine four first insulation parameters of the electrical insulation in accordance with a polarization equivalent circuit diagram in the form of a parallel insulation capacitance (C$_{iso}$), a parallel insulation loss resistance (R$_{iso}$), a first polarization resistance (R$_{Pol1}$) and a first polarization capacitance (C$_{Pol1}$), wherein, in accordance with the polarization equivalent circuit diagram, the insulation capacitance (C$_{iso}$), the insulation loss resistance (R$_{iso}$) and the series connection of the first polarization resistance (R$_{Pol1}$) and the first polarization capacitance (C$_{Pol1}$) are connected in parallel.

11. Apparatus according to Claim 10, **characterized in that** the first frequency (f$_1$) and the second frequency (f$_2$) differ from one another by a factor of at least 2 and preferably by a factor of at least 10.

12. Apparatus according to Claim 10 or 11, **characterized in that** the first frequency (f$_1$) lies in the range between 0.01 Hz and 1 Hz.

13. Apparatus according to any one of Claims 10 to 12, **characterized in that** the second frequency (f$_2$) is a power-line frequency, in particular 50 Hz or 60 Hz.

14. Apparatus according to any one of Claims 10 to 13, **characterized in that** the source unit (6) is designed to generate the first and the second test signal (PS$_1$, PS$_2$) with a different test voltage in each case.

15. Apparatus according to any one of Claims 10 to 14, **characterized in that** the two first real immittance components are a first real part of the admittance $G_{\omega_1}$ and a first imaginary part of the admittance $B_{\omega_1}$ and the two second real immittance components are a second real part of the admittance $G_{\omega_2}$ and a second imaginary part of the admittance $B_{\omega_2}$, and the control/evaluation unit (9) is designed to determine the insulation capacitance C$_{iso}$ according to:

$$C_{iso} = \frac{-\left(B_{\omega_1}B_{\omega_2}\omega_1^2 + \left(-B_{\omega_1}^2 - B_{\omega_2}^2 - G_{\omega_1}^2 + 2G_{\omega_1}G_{\omega_2} - G_{\omega_2}^2\right)\omega_1\omega_2 + B_{\omega_1}B_{\omega_2}\omega_2^2\right)}{\left(\left(\omega_1^2 - \omega_2^2\right)\left(B_{\omega_1}\omega_2 - B_{\omega_2}\omega_1\right)\right)}$$

determine the insulation loss resistance R$_{iso}$ according to:

$$R_{iso} = \frac{-\left(\left(G_{\omega_1} - G_{\omega_2}\right)\left(\omega_1^2 - \omega_2^2\right)\right)}{\left(B_{\omega_1}^2\omega_2^2 - 2B_{\omega_1}B_{\omega_2}\omega_1\omega_2 + B_{\omega_2}^2\omega_1^2 + G_{\omega_1}^2\omega_2^2 - G_{\omega_1}G_{\omega_2}\omega_1^2 - G_{\omega_1}G_{\omega_2}\omega_2^2 + G_{\omega_2}^2\omega_1^2\right)}$$

determine the first polarization resistance R$_{Pol1}$ according to:

$$R_{pol1} = \left(\left(G_{\omega_1} - G_{\omega_2}\right)\left(\omega_1^2 - \omega_2^2\right)\left(B_{\omega_1}\omega_2 - B_{\omega_2}\omega_1\right)^2\right) \Big/$$
$$\left(\left(B_{\omega_1}\omega_2 - B_{\omega_2}\omega_1\right)^4 + B_{\omega_1}^2\omega_2^2\left(\omega_1^2 + \omega_2^2\right)\left(G_{\omega_1} - G_{\omega_2}\right)^2 - 2B_{\omega_1}B_{\omega_2}\omega_1^3\omega_2\left(G_{\omega_1} - G_{\omega_2}\right)^2\right.$$
$$- 2B_{\omega_1}B_{\omega_2}\omega_1\omega_2^3\left(G_{\omega_1} - G_{\omega_2}\right)^2 + B_{\omega_2}^2\omega_1^4\left(G_{\omega_1} - G_{\omega_2}\right)^2 + B_{\omega_2}^2\omega_1^2\omega_2^2\left(G_{\omega_1} - G_{\omega_2}\right)^2$$
$$\left. + \omega_1^2\omega_2^2\left(G_{\omega_1} - G_{\omega_2}\right)^4\right)$$

and determine the first polarization capacitance $C_{Pol1}$ according to:

$$C_{pol1} = \frac{-\left(\left(\left(B_{\omega_1}\omega_2 - B_{\omega_2}\omega_1\right)^2 + \omega_1^2\left(G_{\omega_1} - G_{\omega_2}\right)^2\right)\left(\left(B_{\omega_1}\omega_2 - B_{\omega_2}\omega_1\right)^2 + \omega_2^2\left(\left(G_{\omega_1} - G_{\omega_2}\right)\right)^2\right)\right)}{\left(\omega_1\omega_2(\omega_1 + \omega_2)\left(G_{\omega_1} - G_{\omega_2}\right)^2\left(B_{\omega_1}\omega_2 - B_{\omega_2}\omega_1\right)(\omega_1 - \omega_2)\right)}$$

where $\omega_1$ is the angular frequency belonging to the first frequency and $\omega_2$ is the angular frequency belonging to the second frequency.

16. Apparatus according to any one of Claims 10 to 15, **characterized in that** the source unit (6) is designed to generate at least one further test signal at a further frequency that differs from the first and second frequency ($f_1$, $f_2$), the measuring unit (7) is designed to apply at least one further test signal within the scope of at least one further measurement to the power supply equipment (2), the measuring unit (6) or the control/evaluation unit (9) is designed to ascertain, on the basis of each further measurement, two further real immittance components of at least one further complex immittance ($\underline{Y}$) lying between the first and the second conductor (3, 5) of the power supply equipment (2) and the control/evaluation unit (9) is further designed to determine, per further measurement on the basis of the first and the second real immittance components and in accordance with a further polarization equivalent circuit diagram, in each case, two further first insulation parameters of the electrical insulation in the form of a further polarization resistance ($R_{Pol2}$) and a further polarization capacitance ($C_{Pol2}$), wherein the series connection of the further polarization resistance ($R_{Pol2}$) and the further polarization capacitance ($C_{Pol2}$) in accordance with the further polarization equivalent circuit diagram is connected parallel to the insulation capacitance ($C_{iso}$), the insulation loss resistance ($R_{iso}$) and the series connection of the first polarization resistance ($R_{Pol1}$) and the first polarization capacitance ($C_{Pol1}$).

17. Apparatus according to any one of Claims 10 to 16, **characterized in that** the control/evaluation unit (9) is designed to determine four second insulation parameters of the electrical insulation in accordance with a Maxwell equivalent circuit diagram and in the form of a first Maxwell resistance ($R_{MW1}$), a first Maxwell capacitance ($C_{MW1}$), a second Maxwell resistance ($R_{MW2}$) and a second Maxwell capacitance ($C_{MW2}$) on the basis of the insulation capacitance ($C_{iso}$), the insulation loss resistance ($R_{iso}$), the first polarization resistance ($R_{Pol1}$) and the first polarization capacitance ($C_{Pol1}$) in accordance with the polarization equivalent circuit diagram, wherein, in accordance with the Maxwell equivalent circuit diagram, the parallel connection of the first Maxwell resistance ($R_{MW1}$) and the first Maxwell capacitance ($C_{MW1}$) and the parallel connection of the second Maxwell resistance ($R_{MW2}$) and the second Maxwell capacitance ($C_{MW2}$) are series connected.

18. Apparatus according to any one of Claims 10 to 17, **characterized in that** the control/evaluation unit (9) is designed to use the determined insulation parameters to ascertain, either directly or indirectly after carrying out subsequent calculations using the insulation parameters, the insulation behaviour of the power supply equipment (2), in particular at least one of the variables of volume-related or mass-related water content of the electrical insulation (4), dry mass component of the electrical insulation (4), ageing state of the electrical insulation (4) and residual service life of the electrical insulation (4).

**Revendications**

1. Procédé de détection de paramètres d'isolation d'une isolation électrique (4) d'une ressource d'alimentation en énergie (2) qui présente un premier et un second conducteur électrique (3, 5) qui sont isolés électriquement l'un contre l'autre au moyen de l'isolation électrique (4), dans lequel

   a) deux premières parts d'immitance réelles d'une première immitance complexe ($\underline{Y}$) se trouvant entre le premier et le second conducteur (3, 5) sont calculées au moyen d'une première mesure réalisé pour une première fréquence ($f_1$) au niveau de la ressource d'alimentation en énergie (2),
   b) et deux secondes parts d'immitance réelles d'une seconde immitance complexe ($\underline{Y}$) sont calculées au moins au moyen d'une seconde mesure réalisé pour une seconde fréquence ($f_2$) différente de la première fréquence ($f_1$) au niveau de la ressource d'alimentation en énergie (2),
   c) quatre premiers paramètres d'isolation de l'isolation électrique (4) sont déterminés au moyen des deux premières parts d'immitance réelles et des deux secondes parts d'immitance réelles selon un schéma équivalent de polarisation sous la forme d'une capacité d'isolation parallèle ($C_{iso}$), d'une résistance de perte d'isolation

parallèle ($R_{iso}$), d'une première résistance de polarisation ($R_{Pol1}$) et d'une première capacité de polarisation ($C_{Pol1}$), dans lequel selon le schéma équivalent de polarisation la capacité d'isolation ($C_{iso}$), la résistance de perte d'isolation ($R_{iso}$) ainsi que le circuit en série de la première résistance de polarisation ($R_{Pol1}$) et de la première capacité de polarisation ($C_{Pol1}$) sont montés en parallèle les uns des autres.

2. Procédé selon la revendication 1, **caractérisé en ce que** la première fréquence ($f_1$) et la seconde fréquence ($f_2$) se distinguent l'une de l'autre d'un facteur d'au moins 2 et de préférence d'un facteur d'au moins 10.

3. Procédé selon la revendication 1 ou 2, **caractérisé en ce que** la première fréquence ($f_1$) se trouve dans la plage entre 0,01 Hz et 1 Hz.

4. Procédé selon l'une des revendications précédentes, **caractérisé en ce que** la seconde fréquence ($f_2$) est une fréquence de réseau, en particulier de 50 Hz ou de 60 Hz.

5. Procédé selon l'une des revendications précédentes, **caractérisé en ce que** les deux mesures sont réalisées avec une tension de vérification différente d'un signal de vérification ($PS_1$, $PS_2$) appliqué.

6. Procédé selon l'une des revendications précédentes, **caractérisé en ce que** les deux premières parts d'immitance réelles sont une première partie réelle d'admittance $G_{\omega1}$ et une première partie imaginaire d'admittance $B_{\omega1}$ et les deux secondes parts d'immitance réelles sont une seconde partie réelle d'admittance $G_{\omega2}$ et une seconde partie imaginaire d'admittance $B_{\omega2}$, et la capacité d'isolation $C_{iso}$ est déterminée selon :

$$C_{iso} = \frac{-(B_{w1}B_{w2}w_1^2 + (-B_{w1}^2 - B_{w2}^2 - G_{w1}^2 + 2G_{w1}G_{w2} - G_{w2}^2)w_1w_2 + B_{w1}B_{w2}w_2^2)}{((w_1^2 - w_2^2)(B_{w1}w_2 - B_{w2}w_1))}$$

la résistance de perte d'isolation $R_{iso}$ selon :

$$R_{iso} = \frac{-((G_{w1} - G_{w2})(w_1^2 - w_2^2))}{(B_{w1}^2w_2^2 - 2B_{w1}B_{w2}w_1w_2 + B_{w2}^2w_1^2 + G_{w1}^2w_2^2 - G_{w1}G_{w2}w_1^2 - G_{w1}G_{w2}w_2^2 + G_{w2}^2w_1^2)}$$

la première résistance de polarisation $R_{Pol1}$ selon :

$$R_{pol1} = ((G_{w1} - G_{w2})(w_1^2 - w_2^2)(B_{w1}w_2 - B_{w2}w_1)^2)/ ((B_{w1}w_2 - B_{w2}w_1)^4 + B_{w1}^2w_2^2(w_1^2 +$$
$$w_2^2)(G_{w1} - G_{w2})^2 - 2B_{w1}B_{w2}w_1^3w_2(G_{w1} - G_{w2})^2 - 2B_{w1}B_{w2}w_1w_2^3(G_{w1} - G_{w2})^2 +$$
$$B_{w2}^2w_1^4(G_{w1} - G_{w2})^2 + B_{w2}^2w_1^2w_2^2(G_{w1} - G_{w2})^2 + w_1^2w_2^2(G_{w1} - G_{w2})^4)$$

et la première capacité de polarisation $C_{Pol1}$ selon :

$$C_{pol1} = \frac{-(((B_{w1}w_2 - B_{w2}w_1)^2 + w_1^2(G_{w1} - G_{w2})^2)((B_{w1}w_2 - B_{w2}w_1)^2 + w_2^2(G_{w1} - G_{w2})^2))}{(w_1w_2(w_1 + w_2)(G_{w1} - G_{w2})^2(B_{w1}w_2 - B_{w2}w_1)(w_1 - w_2))}$$

dans lequel $\omega_1$ est la fréquence angulaire afférente à la première fréquence et $\omega_2$ est la fréquence angulaire afférente à la seconde fréquence.

7. Procédé selon l'une des revendications précédentes, **caractérisé en ce qu'**au moyen d'au moins une autre mesure réalisé pour une autre fréquence différente de la première et de la seconde fréquence ($f_1$, $f_2$) au niveau de la ressource d'alimentation en énergie (2) deux autres parts d'immitance réelles d'une autre immitance complexe sont calculées par autre mesure, et au moyen des première et seconde parts d'immitance réelles selon un autre schéma équivalent de polarisation respectivement deux autres premiers paramètres d'isolation de l'isolation électrique sous la forme d'une autre résistance de polarisation ($R_{Pol2}$) et d'une autre capacité de polarisation ($C_{Pol2}$) sont déterminés par autre mesure, dans lequel le circuit en série de l'autre résistance de polarisation ($R_{Pol2}$) et de l'autre capacité de polarisation ($C_{Pol2}$) selon l'autre schéma équivalent de polarisation est monté en parallèle de la capacité d'isolation ($C_{iso}$), de la résistance de perte d'isolation ($R_{iso}$) ainsi que du circuit en série de la première résistance de polarisation

($R_{Pol1}$) et de la première capacité de polarisation ($C_{Pol1}$).

**8.** Procédé selon l'une des revendications précédentes, **caractérisé en ce qu'**au moyen de la capacité d'isolation ($C_{iso}$), de la résistance de perte d'isolation ($R_{iso}$), de la première résistance de polarisation ($R_{Pol1}$) et de la première capacité de polarisation ($C_{Pol1}$) selon le schéma équivalent de polarisation quatre seconds paramètres d'isolation de l'isolation électrique selon un schéma équivalent de Maxwell et sous la forme d'une première résistance de Maxwell ($R_{MW1}$), d'une première capacité de Maxwell ($C_{MW1}$), d'une seconde résistance de Maxwell ($R_{MW2}$) et d'une seconde capacité de Maxwell ($C_{MW2}$) sont déterminés, dans lequel selon le schéma équivalent de Maxwell le circuit en parallèle de la première résistance de Maxwell ($R_{MW1}$) et de la première capacité de Maxwell ($C_{MW1}$) et le circuit en parallèle de la seconde résistance de Maxwell ($R_{MW2}$) et de la seconde capacité de Maxwell ($C_{MW2}$) sont montés en série.

**9.** Procédé selon l'une des revendications précédentes, **caractérisé en ce qu'**est calculé le comportement d'isolation de la ressource d'alimentation en énergie (2), en particulier au moins une des grandeurs à partir de la part d'eau liée au volume ou à la masse de l'isolation électrique (4), la part de masse sèche de l'isolation électrique (4), l'état de vieillissement de l'isolation électrique (4) et la durée de vie restante de l'isolation électrique (4), au moyen des paramètres d'isolation déterminés soit directement soit indirectement après la réalisation de calculs successifs en utilisant les paramètres d'isolation.

**10.** Dispositif de détection de paramètres d'isolation d'une isolation électrique (4) d'une ressource d'alimentation en énergie (2) qui présente un premier et un second conducteur électrique (3, 5) qui sont isolés électriquement l'un contre l'autre au moyen de l'isolation électrique (4), présentant

a) une unité de source (6) pour la génération d'un premier signal de vérification ($PS_1$) avec une première fréquence ($f_1$) et au moins d'un second signal de vérification ($PS_2$) avec une seconde fréquence ($f_2$) différente de la première fréquence ($f_1$),
b) une unité de mesure (7) qui est conçue afin d'appliquer le premier signal de vérification ($PS_1$) dans le cadre d'une première mesure et le second signal de vérification ($PS_2$) dans le cadre d'une seconde mesure au niveau de la ressource d'alimentation en énergie (2), et
c) une unité de commande et d'évaluation (9) se trouvant en liaison de données avec l'unité de source (6) et l'unité de mesure (7),
d) dans lequel l'unité de mesure (7) ou l'unité de commande et d'évaluation (9) est conçue afin de

d1) calculer au moyen de la première mesure deux premières parts d'immitance réelles d'une première immitance (Y) complexe se trouvant entre le premier et le second conducteur (3, 5) de la ressource d'alimentation en énergie (2), et
d2) calculer au moyen de la seconde mesure deux secondes parts d'immitance réelles d'une seconde immitance (Y) complexe se trouvant entre le premier et le second conducteur (3, 5) de la ressource d'alimentation en énergie (2),

e) dans lequel l'unité de commande et d'évaluation (9) est en outre conçue afin de déterminer au moyen de deux premières parts d'immitance réelles et de deux secondes parts d'immitance réelles quatre premiers paramètres d'isolation de l'isolation électrique selon un schéma équivalent de polarisation sous la forme d'une capacité d'isolation parallèle ($C_{iso}$), d'une résistance de perte d'isolation parallèle ($R_{iso}$), d'une première résistance de polarisation ($R_{Pol1}$) et d'une première capacité de polarisation ($C_{Pol1}$), dans lequel selon le schéma équivalent de polarisation la capacité d'isolation ($C_{iso}$), la résistance de perte d'isolation ($R_{iso}$) ainsi que le circuit en série de la première résistance de polarisation ($R_{Pol1}$) et de la première capacité de polarisation ($C_{Pol1}$) sont montés en parallèle les uns des autres.

**11.** Dispositif selon la revendication 10, **caractérisé en ce que** la première fréquence ($f_1$) et la seconde fréquence ($f_2$) se distinguent l'une de l'autre d'un facteur d'au moins 2 et de préférence d'un facteur d'au moins 10.

**12.** Dispositif selon la revendication 10 ou 11, **caractérisé en ce que** la première fréquence ($f_1$) se trouve dans la plage entre 0,01 Hz et 1 Hz.

**13.** Dispositif selon l'une des revendications 10 à 12, **caractérisé en ce que** la seconde fréquence ($f_2$) est une fréquence de réseau, en particulier de 50 Hz ou de 60 Hz.

**14.** Dispositif selon l'une des revendications 10 à 13, **caractérisé en ce que** l'unité de source (6) est conçue afin de générer le premier et le second signal de vérification (PS$_1$, PS$_2$) avec une tension de vérification respectivement différente.

**15.** Dispositif selon l'une des revendications 10 à 14, **caractérisé en ce que** les deux premières parts d'immitance réelles sont une première partie réelle d'admittance $G_{\omega 1}$ et une première part imaginaire d'admittance $B_{\omega 1}$ et les deux secondes parts d'immitance réelles sont une seconde partie réelle d'admittance $G_{\omega 2}$ et une seconde part imaginaire d'admittance $B_{\omega 2}$, et l'unité de commande et d'évaluation (9) est conçue afin de déterminer la capacité d'isolation C$_{iso}$ selon :

$$C_{iso} = \frac{-(B_{w1}B_{w2}w_1^2 + (-B_{w1}{}^2 - B_{w2}{}^2 - G_{w1}{}^2 + 2G_{w1}G_{w2} - G_{w2}{}^2)w_1 w_2 + B_{w1}B_{w2}w_2^2)}{((w_1^2 - w_2^2)(B_{w1}w_2 - B_{w2}w_1))}$$

la résistance de perte d'isolation R$_{iso}$ selon :

$$R_{iso} = \frac{-((G_{w1} - G_{w2})(w_1^2 - w_2^2))}{(B_{w1}^2 w_2^2 - 2B_{w1}B_{w2}w_1 w_2 + B_{w2}^2 w_1^2 + G_{w1}^2 w_2^2 - G_{w1}G_{w2}w_1^2 - G_{w1}G_{w2}w_2^2 + G_{w2}^2 w_1^2)}$$

la première résistance de polarisation R$_{Pol1}$ selon :

$$R_{pol1} = ((G_{w1} - G_{w2})(w_1^2 - w_2^2)(B_{w1}w_2 - B_{w2}w_1)^2)/ ((B_{w1}w_2 - B_{w2}w_1)^4 + B_{w1}^2 w_2^2(w_1^2 + w_2^2)(G_{w1} - G_{w2})^2 - 2B_{w1}B_{w2}w_1^3 w_2(G_{w1} - G_{w2})^2 - 2B_{w1}B_{w2}w_1 w_2^3(G_{w1} - G_{w2})^2 + B_{w2}^2 w_1^4(G_{w1} - G_{w2})^2 + B_{w2}^2 w_1^2 w_2^2(G_{w1} - G_{w2})^2 + w_1^2 w_2^2(G_{w1} - G_{w2})^4)$$

et la première capacité de polarisation C$_{Pol1}$ selon :

$$C_{pol1} = \frac{-(((B_{w1}w_2 - B_{w2}w_1)^2 + w_1^2(G_{w1} - G_{w2})^2)((B_{w1}w_2 - B_{w2}w_1)^2 + w_2^2(G_{w1} - G_{w2})^2))}{(w_1 w_2(w_1 + w_2)(G_{w1} - G_{w2})^2(B_{w1}w_2 - B_{w2}w_1)(w_1 - w_2))}$$

dans lequel $\omega_1$ est la fréquence angulaire afférente à la première fréquence et $\omega_2$ est la fréquence angulaire afférente à la seconde fréquence.

**16.** Dispositif selon l'une des revendications 10 à 15, **caractérisé en ce que** l'unité de source (6) est conçue afin de générer au moins un autre signal de vérification avec une autre fréquence différente de la première et de la seconde fréquence (f$_1$, f$_2$), l'unité de mesure (7) est conçue afin d'appliquer l'au moins un autre signal de vérification dans le cadre au moins d'une autre mesure au niveau de la ressource d'alimentation en énergie (2), l'unité de mesure (6) ou l'unité de commande et d'évaluation (9) est conçue afin de calculer par autre mesure deux autres parts d'immitance réelles au moins d'une autre immitance complexe (Y) se trouvant entre le premier et le second conducteur (3, 5) de la ressource d'alimentation en énergie (2), et l'unité de commande et d'évaluation (9) est en outre conçue afin de déterminer par autre mesure au moyen des première et seconde parts d'immitance réelles selon un autre schéma équivalent de polarisation respectivement deux autres premiers paramètres d'isolation de l'isolation électrique sous la forme d'une autre résistance de polarisation (R$_{Pol2}$) et d'une autre capacité de polarisation (C$_{Pol2}$), dans lequel le circuit en série de l'autre résistance de polarisation (R$_{Pol2}$) et de l'autre capacité de polarisation (C$_{Pol2}$) selon l'autre schéma équivalent de polarisation est monté en parallèle de la capacité d'isolation (C$_{iso}$), de la résistance de perte d'isolation (R$_{iso}$) ainsi que du circuit en série de la première résistance de polarisation (R$_{Pol1}$) et de la première capacité de polarisation (C$_{Pol1}$).

**17.** Dispositif selon l'une des revendications 10 à 16, **caractérisé en ce que** l'unité de commande et d'évaluation (9) est conçue afin de déterminer au moyen de la capacité d'isolation (C$_{iso}$), de la résistance de perte d'isolation (R$_{iso}$), de la première résistance de polarisation (R$_{Pol1}$) et de la première capacité de polarisation (C$_{Pol1}$) selon le schéma équivalent de polarisation quatre seconds paramètres d'isolation de l'isolation électrique selon un schéma équivalent de Maxwell et sous la forme d'une première résistance de Maxwell (R$_{MW1}$), d'une première capacité de Maxwell (C$_{MW1}$), d'une seconde résistance de Maxwell (R$_{MW2}$) et d'une seconde capacité de Maxwell (C$_{MW2}$), dans lequel selon le schéma équivalent de Maxwell le circuit en parallèle de la première résistance de Maxwell ($R_{MW1}$) et de la première capacité de Maxwell ($C_{MW1}$) et le circuit en parallèle de la seconde résistance de Maxwell ($R_{MW2}$) et de la seconde capacité de Maxwell ($C_{MW2}$) sont montés en série.

18. Dispositif selon l'une des revendications 10 à 17, **caractérisé en ce que** l'unité de commande et d'évaluation (9) est conçue afin de calculer, au moyen de paramètres d'isolation déterminés soit directement soit indirectement après la réalisation de calculs successifs en utilisant les paramètres d'isolation, le comportement d'isolation de la ressource d'alimentation en énergie (2), en particulier au moins une des grandeurs à partir de la part d'eau liée au volume ou à la masse de l'isolation électrique (4), la part de masse sèche de l'isolation électrique (4), l'état de vieillissement de l'isolation électrique (4) et la durée de vie restante de l'isolation électrique (4).

Fig. 1

EP 3 599 472 B1

Fig. 2

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- Diagnostic System for Off-Line Diagnosis of MV Cables. **THOMAS SCHARRER.** Proc. of the Conference on Diagnostics in Electrical Engineering CDEE 2016. IEEE, 06. September 2016, 1-4

- **FENG YANG.** A Parameterization Approach for the Dielectric Response Model of Oil Paper Insulation Using FDS Measurements. *Energies 2018,* 10. Marz 2018, vol. 11 (3), 1-17